# EUROPEAN PATENT APPLICATION

(11) **EP 1 643 307 A1**
(43) Date of publication of application: **05.04.2006**
(21) Application number: 04745842.7
(22) Date of filing: 08.06.2004
(51) Int. Cl.: G03F 7/075, G03F 7/039

(54) **POSITIVE RESIST COMPOSITION, RESIST LAMINATES AND PROCESS FOR THE FORMATION OF RESIST PATTERNS**

(30) Priority: 11.06.2003 JP 2003166391; 12.06.2003 JP 2003168130; 06.04.2004 JP 2004112511; 06.04.2004 JP 2004112512
(71) Applicant: TOKYO OHKA KOGYO CO., LTD., Kawasaki-shi, Kanagawa 211-0012 (JP)
(72) Inventor: TAMURA, Koki, c/o Tokyo Ohka Kogyo Co., Ltd., Kawasaki-shi, Kanagawa 211-0012 (JP); KAWANA, Daisuke, c/o Tokyo Ohka Kogyo Co., Ltd., Kawasaki-shi, Kanagawa 211-0012 (JP); YAMADA, Tomotaka, c/o Tokyo Ohka Kogyo Co., Ltd., Kawasaki-shi, Kanagawa 211-0012 (JP); HOSONO, Takayuki, c/o Tokyo Ohka Kogyo Co., Ltd., Kawasaki-shi, Kanagawa 211-0012 (JP); HIRAYAMA, Taku, c/o Tokyo Ohka Kogyo Co., Ltd., Kawasaki-shi, Kanagawa 211-0012 (JP); SATO, Kazufumi, c/o Tokyo Ohka Kogyo Co., Ltd., Kawasaki-shi, Kanagawa 211-0012 (JP); SHIMBORI, Hiroshi, c/o Tokyo Ohka Kogyo Co., Ltd., Kawasaki-shi, Kanagawa 211-0012 (JP); ANDO, Tomoyuki, c/o Tokyo Ohka Kogyo Co., Ltd., Kawasaki-shi, Kanagawa 211-0012 (JP)
(74) Representative: Hinkelmann, Klaus
(86) International application number: PCT/JP2004/008282
(87) International publication number: WO 2004/111734

(57) **Abstract**

A positive resist composition, comprising a resin component (A) that exhibits increased alkali solubility under the action of acid, and an acid generator component (B) that generates acid on exposure, wherein the component (A) includes either a silsesquioxane resin (A1) containing structural units (a1) represented by a general formula (I) shown below, structural units (a2) represented by a general formula (II) shown below, and structural units (a3) represented by a general formula (III) shown below, or a silsesquioxane resin (A2) containing structural units (a1) represented by the general formula (I) shown below, and structural units (a2') represented by a general formula (II') shown below. In the general formulas below, R¹ represents a straight-chain or branched alkylene group of 1 to 5 carbon atoms, R² represents a straight-chain or branched alkylene group of 1 to 5 carbon atoms, R³ represents an acid dissociable, dissolution inhibiting group, R⁶ represents an alkyl group of 1 to 5 carbon atoms, R⁷ represents either an alkyl group of 1 to 5 carbon atoms or a hydrogen atom, and R⁸ represents an alicyclic hydrocarbon group of 5 to 15 carbon atoms.

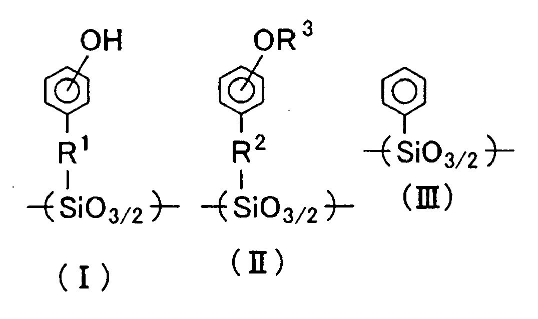

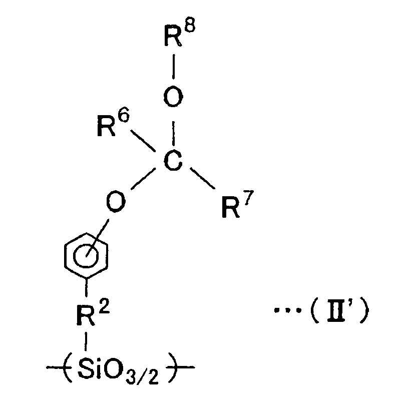

## Description

### TECHNICAL FIELD

The present invention relates to a positive resist composition containing a silsesquioxane resin, a resist laminate containing such a positive resist within the upper layer of a two-layer resist process, and a process for forming a resist pattern that uses such a resist laminate.

Priority is claimed on Japanese Patent Application No. 2003-166391, filed June 11, 2003, Japanese Patent Application No. 2003-168130, filed June 12, 2003, Japanese Patent Application No. 2004-112511, filed April 6, 2004, and Japanese Patent Application No. 2004-112512, filed April 6, 2004, the contents of which are incorporated herein by reference.

### BACKGROUND ART

In the production of semiconductor elements and liquid crystal display elements, a lithography step, in which a circuit pattern (resist pattern) is formed in a resist provided on top of a substrate, and an etching step, in which the formed resist pattern is used as a mask to partially etch and remove the insulating film or conductive film formed as a base material on top of the substrate, are performed.

In recent years, advances in lithography techniques have lead to ongoing, rapid miniaturization of resist patterns. Recently, levels of resolution capable of forming line and space patterns of no more than 100 nm, and isolated patterns of no more than 70 nm, are being demanded.

However, with this type of single layer resist process, achieving a high resolution and a favorable pattern shape is far from easy, and realizing this type of high resolution and favorable pattern shape at a high aspect ratio is even more difficult.

On the other hand, a two-layer resist process using a chemically amplified resist has been proposed as one process that enables the formation of a resist pattern with high resolution and a high aspect ratio (for example, see patent references 1, 2, 3, and 4). In this process, first, an organic film is formed as a lower organic layer on top of a substrate, and an upper resist layer is then formed on top using a chemically amplified resist. Subsequently, a resist pattern is formed in the upper resist layer using photolithography techniques, and by then using this resist pattern as a mask to conduct etching, thereby transferring the resist pattern to the lower organic layer, a resist pattern with a high aspect ratio is formed.

Furthermore, the patent references 2 through 4 below propose the use of chemically amplified resists that use a silsesquioxane resin containing a structural unit into which an acid dissociable, dissolution inhibiting group has been introduced as an ideal material for the upper resist layer in a two-layer resist process.

However, conventional chemically amplified resists that use a silicone resin can no longer provide completely satisfactory lithography characteristics such as depth of focus and exposure margin.
(Patent Reference 1)
Japanese Unexamined Patent Application, First Publication No. Hei 6-202338
(Patent Reference 2)
Japanese Unexamined Patent Application, First Publication No. Hei 8-29987
(Patent Reference 3)
Japanese Unexamined Patent Application, First Publication No. Hei 8-160620
(Patent Reference 4)
Japanese Unexamined Patent Application, First Publication No. Hei 9-87391

Furthermore, the acid dissociable, dissolution inhibiting groups disclosed in the above patent references, including tert-butoxycarbonyl groups, tert-butoxycarbonylmethyl groups, and tetrahydropyranyl groups and the like, all exhibit resistance to complete dissociation, even in the presence of strong acids.

As a result, non-dissociated acid dissociable, dissolution inhibiting groups remain within the polymer, causing developing defects, and meaning that a variety of properties, including the line edge roughness of the resist pattern, the shape characteristics such as the cross-sectional shape, and lithography characteristics such as the depth of focus and the exposure margin are not entirely satisfactory.

### DISCLOSURE OF INVENTION

The present invention aims to resolve these problems, with an object of providing a positive resist composition with excellent resist pattern shape characteristics and excellent lithography characteristics, as well as a resist laminate that uses such a resist composition, and a process for forming a resist pattern that uses such a resist laminate.

As a result of intensive investigations, the inventors of the present invention discovered that a positive resist composition containing a silsesquioxane resin with specific structural units as the base resin, a resist laminate that used this positive resist composition, and a process for forming a resist pattern that used this resist laminate were able to achieve the above object, and they were thus able to complete the present invention.

In other words, a first aspect of the present invention for achieving the above object is a positive resist composition that includes a resin component (A) that exhibits increased alkali solubility under the action of acid, and an acid generator component (B) that generates acid on exposure, wherein the component (A) includes a silsesquioxane resin (A1) containing structural units (a1) represented by a general formula (I) shown below, structural units (a2) represented by a general formula (II) shown below, and structural units (a3) represented by a general formula (III) shown below. 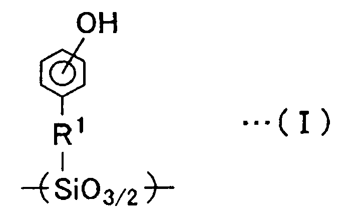 (wherein, R¹ represents a straight-chain or branched alkylene group of 1 to 5 carbon atoms) 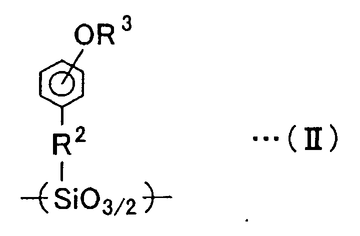 (wherein, R² represents a straight-chain or branched alkylene group of 1 to 5 carbon atoms, and R³ represents an acid dissociable, dissolution inhibiting group)

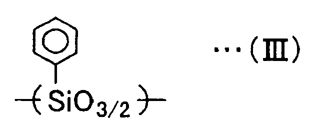

A second aspect of the present invention is a positive resist composition that includes a resin component (A) that exhibits increased alkali solubility under the action of acid, and an acid generator component (B) that generates acid on exposure, wherein the component (A) includes a silsesquioxane resin (A2) containing structural units (a1) represented by the general formula (I) shown above, and structural units (a2') represented by a general formula (II') shown below. 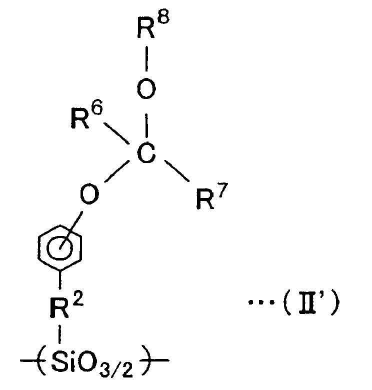 (wherein, R² represents a straight-chain or branched alkylene group of 1 to 5 carbon atoms, R⁶ represents an alkyl group of 1 to 5 carbon atoms, R⁷ represents either an alkyl group of 1 to 5 carbon atoms or a hydrogen atom, and R⁸ represents an alicyclic hydrocarbon group of 5 to 15 carbon atoms)

In this positive resist composition of the present invention, the component (A2) preferably also includes structural units (a3) represented by the above general formula (III).

A third aspect of the present invention is a resist laminate that includes a lower organic layer and an upper resist layer laminated on top of a support, wherein the lower organic layer is insoluble in alkali developing solution, but can by dry etched, and the upper resist layer is formed from a positive resist composition according to the present invention.

A fourth aspect of the present invention is a process for forming a resist pattern, including a laminate formation step of forming a resist laminate of the present invention; a first pattern formation step of conducting selective exposure of the resist laminate, performing post exposure baking (PEB), and then conducting alkali developing to form a resist pattern (I) in the upper resist layer; a second pattern formation step of conducting dry etching using the resist pattern (I) as a mask, thereby forming a resist pattern (II) in the lower organic layer; and an etching step of conducting etching using the resist patterns (I) and (II) as a mask, thereby forming a fine pattern in the support.

In this description, the term "structural unit" refers to a monomer unit that contributes to the formation of a polymer.

### Effects of the Invention

According to the present invention, a positive resist composition with excellent lithography characteristics such as depth of focus and exposure margin and excellent resist pattern shape characteristics can be realized, together with a resist laminate that uses such a resist composition, and a process for forming a resist pattern that uses such a resist laminate.

### BEST MODE FOR CARRYING OUT THE INVENTION

As follows is a description of embodiments of the present invention.

### [Resist Composition]

### <Component (A)>

The resin component (A) of a positive resist composition of the first aspect of the present invention includes a silsesquioxane resin (A1) containing structural units (a1) represented by the general formula (I) shown above, structural units (a2) represented by the general formula (II) shown above, and structural units (a3) represented by the general formula (III) shown above.

In the structural units (a1), in terms of resin synthesis, the group R¹ is preferably a lower alkylene group of 1 to 5 carbon atoms, and is most preferably a methylene group. The bonding position of the hydroxyl group may be the o-position, the m-position or the p-position, although the p-position is preferred industrially.

Similarly, in the structural units (a2), from the viewpoint of resin synthesis, the group R² is preferably a lower alkylene group of 1 to 5 carbon atoms, and is most preferably a methylene group.

The group R³ within the structural units (a2) is an acid dissociable, dissolution inhibiting group. In the present invention, an "acid dissociable, dissolution inhibiting group" is a group which has an alkali solubility inhibiting effect that renders the entire silsesquioxane resin insoluble in alkali prior to exposure, but then dissociates under the action of acid generated from the acid generator component (B) following exposure, causing the entire silsesquioxane resin to become alkali soluble. Accordingly, when a resist composition containing this silsesquioxane resin is applied to a substrate and then irradiated through a mask pattern, the alkali solubility of the exposed portions increases, meaning alkali developing can then be used to form a resist pattern.

The group R³ may be any acid dissociable, dissolution inhibiting group that can be substituted for the hydrogen atom of a phenolic hydroxyl group, and any of the multitude of proposed groups can be selected and used, in accordance with the light source used for the exposure. Specific examples of suitable groups include tertiary alkyloxycarbonyl groups such as a tert-butoxycarbonyl group or tert-amyloxycarbonyl group; tertiary alkyl groups such as a tert-butyl group or tert-amyl group; tertiary alkoxycarbonylalkyl groups such as a tert-butoxycarbonylmethyl group or tert-butoxycarbonylethyl group; lower alkoxyalkyl groups such as a 1-ethoxyethyl group, 1-isopropoxyethyl group, 1-methoxy-1-methylethyl group, 1-methoxypropyl group, or 1-n-butoxyethyl group; and cyclic ether groups such as a tetrahydropyranyl group or tetrahydrofuranyl group. Of these, a lower alkoxyalkyl group exhibits a particularly low energy of dissociation, which enables a favorable solubility contrast to be achieved with ease, and enables an improvement in lithography characteristics, and is consequently preferred. In the lower alkoxyalkyl group, the number of carbon atoms of the alkoxy group is preferably from 1 to 3, and the number of carbon atoms within the alkyl group is preferably from 1 to 6, and of the possible groups, a 1-ethoxyethyl group is particularly preferred. The bonding position of the (-OR³) group may be the o-position, the m-position or the p-position, although the p-position is preferred industrially.

In addition to the structural units (a1) to (a3) described above, the component (A1) may also contain a structural unit (a4), provided such inclusion does not impair the effects of the present invention. Specific examples of this other structural unit (a4) include structural units represented by a general formula (IV) shown below. 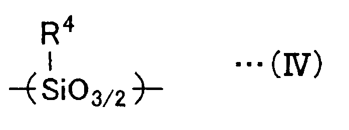 (wherein, R⁴ represents a straight-chain, branched, or cyclic alkyl group of 1 to 15 carbon atoms)

The proportions of each of the structural units within the resin, relative to the combined total of all the structural units of the component (A1), are preferably at least 50 mol% for the combination of the structural units (a1) and the structural units (a2), with the remainder, namely 50 mol% or less, accounted for by either the structural units (a3), or the combination of the structural units (a3) and the structural units (a4). Furthermore, the quantity of the structural units (a2) relative to the combined total of the structural units (a1) and (a2) is preferably at least 8 mol%.

If the combined total of the structural units (a1) and (a2) accounts for less than 50 mol%, then there is a danger that the solubility during the alkali developing step may be unsatisfactory. In contrast, because the structural units (a3) contribute to an improvement in the heat resistance, if the quantity of the structural units (a3) within the component (A1) is less than 10%, then a satisfactory heat resistance improvement effect cannot be obtained.

Accordingly, the combined total of (a1) and (a2) preferably accounts for 50 to 90 mol%, and even more preferably 60 to 80 mol%, whereas the structural units (a3), or the combination of the of the structural units (a3) and the structural units (a4) preferably account for 10 to 50 mol%, and even more preferably 20 to 40 mol%.

The lower the proportion of (a2) within the combination of the structural units (a1) and (a2), the smaller the dissolution inhibiting effect of introducing the acid dissociable, dissolution inhibiting groups (R³) becomes, and the smaller the change in alkali solubility of the component (A1) will be upon exposure. In contrast, if the proportion of the structural units (a2) is too high, then there is a danger that a portion of the acid dissociable, dissolution inhibiting groups will remain in a non-dissociated state, even after exposure and PEB. These residual acid dissociable, dissolution inhibiting groups that have not dissociated are not removed during rinsing, and frequently cause defects. Furthermore, if the quantity of the structural units (a2) is high, the heat resistance of the component (A) tends to decrease.

Accordingly, the proportion of the structural units (a2) relative to the combination of the structural units (a1) and (a2) is preferably within a range from 8 to 25 mol%, and even more preferably from 10 to 20 mol%.

In those cases where the shape of the targeted resist pattern is a line and space pattern, the higher the proportion of the structural units (a3) within the component (A1), the greater the improvement in line edge roughness. In such cases, the proportion of the structural units (a3) is preferably within a range from 25 to 50 mol%, and even more preferably from 30 to 40 mol%.

Furthermore, in those cases where the shape of the targeted resist pattern is a hole pattern, although higher proportions of the structural units (a3) within the component (A1) generate greater improvements in the hole pattern edge roughness, the resolution tends to deteriorate, and consequently the proportion of the structural units (a3) is preferably within a range from 25 to 35 mol%, and even more preferably from 25 to 30 mol%.

In those cases where the aforementioned other structural unit (a4) is included within the component (A1), the proportion of (a4) is preferably no more than 25 mol%, and even more preferably 15 mol% or less.

The resin component (A) of a positive resist composition of the second aspect of the present invention includes a silsesquioxane resin (A2) containing structural units (a1) represented by the general formula (I) shown above, and structural units (a2') represented by the general formula (II') shown above.

In the structural units (a1), in terms of resin synthesis, the group R¹ is typically a straight-chain or branched alkylene group of 1 to 5 carbon atoms, and is preferably a straight-chain or branched alkylene group of 1 to 3 carbon atoms. Of these groups, a methylene group is particularly desirable. The bonding position of the hydroxyl group may be the o-position, the m-position or the p-position, although the p-position is preferred industrially.

In the structural units (a2'), in terms of resin synthesis, the group R² is typically a straight-chain or branched alkylene group of 1 to 5 carbon atoms, and is preferably a straight-chain or branched alkylene group of 1 to 3 carbon atoms.

In the structural units (a2'), the functional group represented by the general formula (VI) shown below functions as an acid dissociable, dissolution inhibiting group.

It has the same function as the "acid dissociable, dissolution inhibiting groups" described above.

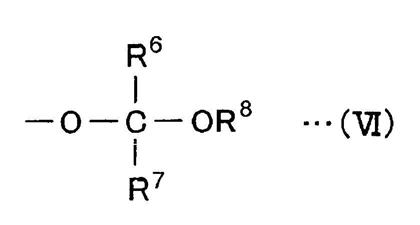

In this formula, R⁶ represents an alkyl group of 1 to 5 carbon atoms, and preferably a methyl group or an ethyl group. R⁷ represents either an alkyl group of 1 to 5 carbon atoms or a hydrogen atom, and is preferably a hydrogen atom. R⁸ represents an alicyclic hydrocarbon group of 5 to 15 carbon atoms, and is preferably a cycloalkyl group of 5 to 7 carbon atoms such as a cyclopentyl group or cyclohexyl group, although from an industrial viewpoint, a cyclohexyl group results in lower costs and is consequently the most preferred. The bonding position of the acid dissociable, dissolution inhibiting group represented by the general formula (VI) may be the o-position, the m-position or the p-position, although the p-position is preferred industrially.

The component (A2) may also include structural units (a3) represented by the aforementioned general formula (III).

Furthermore, in addition to the structural units (a1), (a2'), and (a3) described above, the component (A2) may also contain a structural unit (a4), provided such inclusion does not impair the effects of the present invention. Specific examples of this other structural unit (a4) include structural units represented by the aforementioned general formula (IV).

The proportions of each of the structural units within the resin, relative to the combined total of all the structural units of the component (A2), preferably total at least 50 mol% for the combination of the structural units (a1) and the structural units (a2'), and this combination may also total 100 mol%. The combination of (a1) and (a2') preferably accounts for 50 to 90 mol%, and even more preferably 60 to 80 mol%.

The remainder, namely 50 mol% or less, is accounted for by either the structural units (a3), or the combination of the structural units (a3) and (a4).

If the combined total of the structural units (a1) and (a2') accounts for less than 50 mol%, then there is a danger that the solubility during the alkali developing step may be unsatisfactory.

The portion of (a2') units within the combination of the structural units (a1) and (a2') is preferably within a range from 5 to 50 mol%, and even more preferably from 5 to 15 mol%.

The lower the proportion of (a2') units within the combination of the structural units (a1) and (a2'), the smaller the dissolution inhibiting effect of the acid dissociable, dissolution inhibiting groups becomes, and the smaller the change in alkali solubility of the silsesquioxane resin (A2) will be upon exposure. In contrast, if the proportion of the (a2') units is too high, then there is a danger that a portion of the acid dissociable, dissolution inhibiting groups will remain in a non-dissociated state, even after exposure and PEB. These residual acid dissociable, dissolution inhibiting groups that have not dissociated are not removed during rinsing, and frequently cause defects. Defects are particularly likely in the case of hole patterns. Furthermore, if the quantity of the structural units (a2') is high, the heat resistance of the component (A) tends to decrease.

Accordingly, the proportion of (a2') units relative to the combination of the structural units (a1) and (a2') is preferably within a range from 5 to 50 mol%, and even more preferably from 5 to 15 mol%.

Although the structural unit (a3) is not essential, inclusion of structural units (a3) within the component (A2) improves the heat resistance of the resist pattern. Furthermore, in those cases where the shape of the targeted resist pattern is a line and space pattern, including the structural units (a3) within the component (A2) causes an effective improvement in the line edge roughness. In such cases, the proportion of the structural units (a3) within the component (A2) is preferably within a range from 20 to 50 mol%, and even more preferably from 30 to 40 mol%.

In those cases where the aforementioned other structural unit (a4) is included within the component (A2), the proportion of these units (a4) is preferably no more than 20 mol%, and even more preferably 15 mol% or less.

There are no particular restrictions on the weight average molecular weight (Mw) (the polystyrene equivalent value determined by gel permeation chromatography (hereafter abbreviated as GPC), this also applies to all subsequent values) of the silsesquioxane resin used as the component (A1) or the component (A2), although the value is preferably within a range from 2,000 to 15,000, and even more preferably from 5,000 to 10,000. If the weight average molecular weight is larger than this range, then the solubility within organic solvents deteriorates, whereas if the value is smaller than the above range, there is a danger of a deterioration in the cross-sectional shape of the resist pattern.

Furthermore, although there are no particular restrictions on the ratio Mw/Mn (number average molecular weight), the ratio is preferably within a range from 1.0 to 6.0, and even more preferably from 1.0 to 2.0. If this ratio is larger than this range, then there is a danger of a deterioration in both the resolution and the pattern shape.

A silsesquioxane resin (A1) or (A2) of the present invention can be produced using the method disclosed in Japanese Patent (Granted) Publication No. 2,567,984, which is also described in the synthesis examples below, wherein a polymer is formed from either structural units (a1) and structural units (a3), or structural units (a1), structural units (a3), and structural units (a4), and a conventional technique is then used to substitute the hydrogen atoms from a portion of the side-chain phenolic hydroxyl groups of the structural units (a1) with acid dissociable, dissolution inhibiting groups. The structural units (a4) can be formed using either an alkyltrialkoxysilane or an alkyltrichlorosilane as a monomer.

In the silsesquioxane resin (A1), during the step for introducing the acid dissociable, dissolution inhibiting groups, the aforementioned polymer is dissolved in an organic solvent, a basic or acid catalyst is added, together with the compound that corresponds with the acid dissociable, dissolution inhibiting group to be introduced, the resulting mixture is reacted for approximately 1 to 10 hours at a temperature of approximately 20 to 70°, and following subsequent neutralization of the reaction solution by addition of an acid or base, the reaction mixture is stirred into water to precipitate the polymer, thus yielding a polymer containing either structural units (a1), structural units (a2), and structural units (a3), or structural units (a1), structural units (a2), structural units (a3), and structural units (a4). The basic or acid catalyst should use a compound most suited to the acid dissociable, dissolution inhibiting group.

The proportion of the structural units (a1) and (a2) can be controlled by adjusting the quantity added of the compound that corresponds with the acid dissociable, dissolution inhibiting group to be introduced.

In those cases where a silsesquioxane resin (A2) contains structural units (a1) and structural units (a2'), the resin can be produced by first forming a polymer from the structural units (a1) using a conventional polymerization method, and then using a conventional technique to introduce acid dissociable, dissolution inhibiting groups at a portion of the side-chain phenolic hydroxyl groups of the structural units (a1).

A silsesquioxane resin containing structural units (a1), structural units (a2'), and structural units (a3) can be produced using the method disclosed in Japanese Patent (Granted) Publication No. 2,567,984, as described in the synthesis examples below, wherein a polymer is formed from the structural units (a1) and the structural units (a3), and a conventional technique is then used to introduce acid dissociable, dissolution inhibiting groups at a portion of the side-chain phenolic hydroxyl groups of the structural units (a1).

Furthermore, a silsesquioxane resin containing structural units (a1), structural units (a2'), structural units (a3), and structural units (a4) can be produced, for example, by forming a polymer from the structural units (a1), the structural units (a3), and the structural unit (a4), and then using a conventional technique to introduce acid dissociable, dissolution inhibiting groups at a portion of the side-chain phenolic hydroxyl groups of the structural units (a1).

The structural units (a4) can be formed using either an alkyltrialkoxysilane or an alkyltrichlorosilane as a monomer.

In the step for introducing the acid dissociable, dissolution inhibiting groups, the polymer formed from the structural units (a1), the polymer formed from the structural units (a1) and the structural units (a3), or the polymer formed from the structural units (a1), the structural units (a3), and the structural units (a4) is dissolved in an organic solvent, a basic or acid catalyst is added, together with the compound that corresponds with the acid dissociable, dissolution inhibiting group to be introduced, the resulting mixture is reacted for approximately 1 to 10 hours at a temperature of approximately 20 to 70°, and following subsequent neutralization of the reaction solution by addition of an acid or base, the reaction mixture is stirred into water to precipitate the polymer, thus yielding a polymer of the structural units described above to which structural units (a2') have been added. The basic or acid catalyst should use a compound most suited to the acid dissociable, dissolution inhibiting group.

The proportion of the structural units (a2') can be controlled by adjusting the quantity added of the compound that corresponds with the acid dissociable, dissolution inhibiting group being introduced.

### <Component (B)>

As the component (B), a compound appropriately selected from known materials used as acid generators in conventional chemically amplified resists can be used.

Examples of these acid generators are numerous, and include onium salt-based acid generators such as iodonium salts and sulfonium salts, oxime sulfonate-based acid generators, diazomethane-based acid generators such as bisalkyl or bisaryl sulfonyl diazomethanes, poly(bis-sulfonyl)diazomethanes, and diazomethane nitrobenzyl sulfonates, iminosulfonate-based acid generators, and disulfone-based acid generators.

Specific examples of suitable onium salt-based acid generators include diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate, heptafluoropropanesulfonate or nonafluorobutanesulfonate, tri(4-methylphenyl)sulfonium trifluoromethanesulfonate, heptafluoropropanesulfonate or nonafluorobutanesulfonate, (4-methylphenyl)diphenylsulfonium trifluoromethanesulfonate, heptafluoropropanesulfonate or nonafluorobutanesulfonate, (4-methoxyphenyl)diphenylsulfonium trifluoromethanesulfonate, heptafluoropropanesulfonate or nonafluorobutanesulfonate, dimethyl(4-hydroxynaphthyl)sulfonium trifluoromethanesulfonate, heptafluoropropanesulfonate or nonafluorobutanesulfonate, and monophenyldimethylsulfonium trifluoromethanesulfonate, heptafluoropropanesulfonate or nonafluorobutanesulfonate. Of these, onium salts with a fluorinated alkylsulfonate ion as the anion are preferred.

Specific examples of suitable oxime sulfonate-based acid generators include α-(methylsulfonyloxyimino)-phenylacetonitrile, α-(methylsulfonyloxyimino)-p-methoxyphenylacetonitrile, α-(trifluoromethylsulfonyloxyimino)-phenylacetonitrile, α-(trifluoromethylsulfonyloxyimino)-p-methoxyphenylacetonitrile, α-(ethylsulfonyloxyimino)-p-methoxyphenylacetonitrile, α-(propylsulfonyloxyimino)-p-methylphenylacetonitrile, α-(methylsulfonyloxyimino)-p-bromophenylacetonitrile, and bis-o-(n-butylsulfonyl)-α-dimethylglyoxime. Of these, α-(methylsulfonyloxyimino)-p-methoxyphenylacetonitrile and bis-o-(n-butylsulfonyl)-α-dimethylglyoxime are preferred.

Specific examples of suitable diazomethane-based acid generators include bisalkyl sulfonyl diazomethanes with a straight-chain or branched alkyl group of 1 to 4 carbon atoms, such as bis(n-propylsulfonyl)diazomethane, bis(isopropylsulfonyl)diazomethane, bis(n-butylsulfonyl)diazomethane, bis(isopropylsulfonyl)diazomethane, and bis(tert-butylsulfonyl)diazomethane; bisalkyl sulfonyl diazomethanes with a cyclic alkyl group of 5 to 6 carbon atoms, such as bis(cyclopentylsulfonyl)diazomethane and bis(cyclohexylsulfonyl)diazomethane; and bisaryl sulfonyl diazomethanes with an aryl group, such as bis(p-toluenesulfonyl)diazomethane and bis(2,4-dimethylphenylsulfonyl)diazomethane.

Furthermore, specific examples of poly(bis-sulfonyl)diazomethanes include the structures shown below, such as 1,3-bis(phenylsulfonyldiazomethylsulfonyl)propane (compound A, decomposition point 135°C), 1,4-bis(phenylsulfonyldiazomethylsulfonyl)butane (compound B, decomposition point 147°C), 1,6-bis(phenylsulfonyldiazomethylsulfonyl)hexane (compound C, melting point 132°C, decomposition point 145°C), 1,10-bis(phenylsulfonyldiazomethylsulfonyl)decane (compound D, decomposition point 147°C), 1,2-bis(cyclohexylsulfonyldiazomethylsulfonyl)ethane (compound E, decomposition point 149°C), 1,3-bis(cyclohexylsulfonyldiazomethylsulfonyl)propane (compound F, decomposition point 153°C), 1,6-bis(cyclohexylsulfonyldiazomethylsulfonyl)hexane (compound G, melting point 109°C, decomposition point 122°C), and 1,10-bis(cyclohexylsulfonyldiazomethylsulfonyl)decane (compound H, decomposition point 116°C).

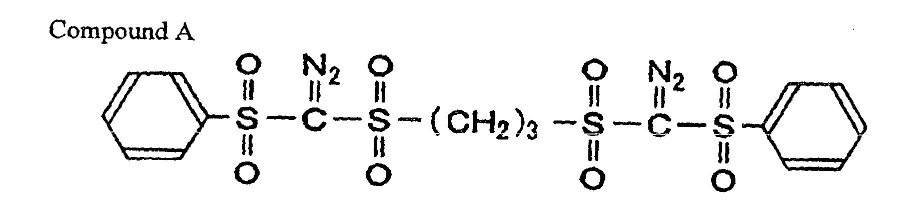

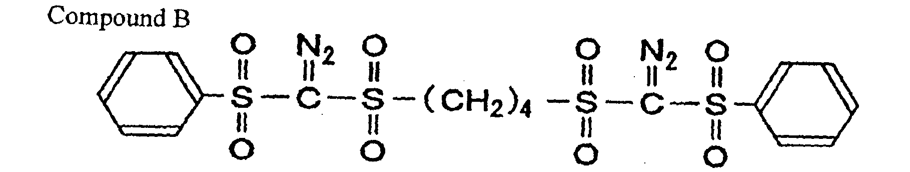

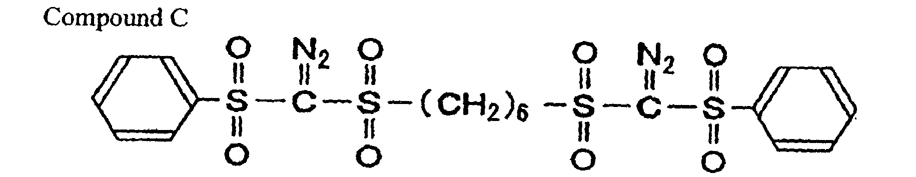

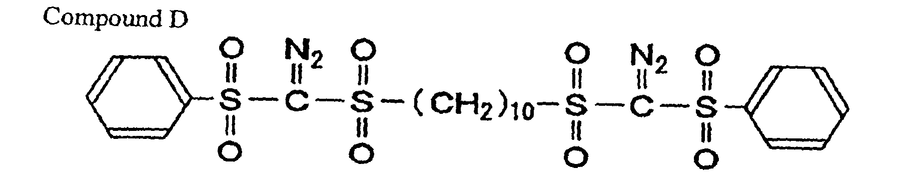

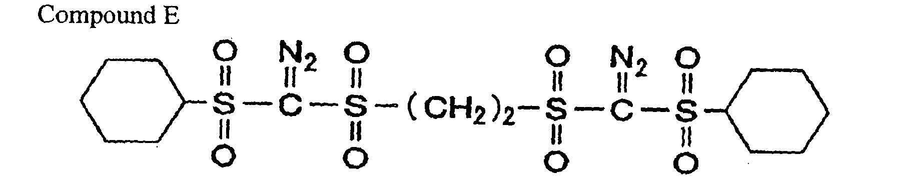

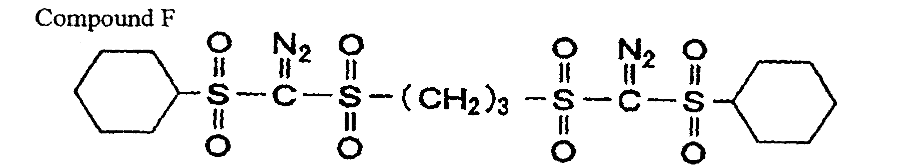

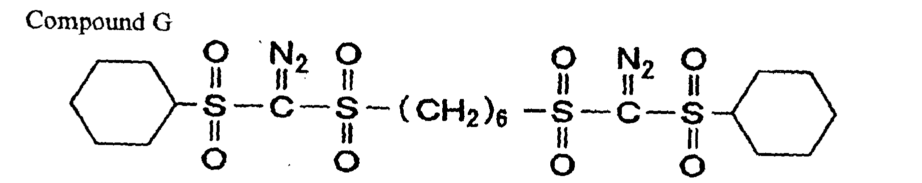

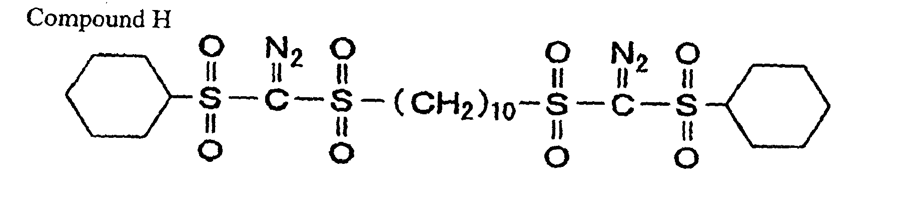

Onium salts offer excellent depth of focus and exposure margin, and are consequently preferred. Furthermore, diazomethanes enable an improvement in the circularity of resist hole patterns and suppression of standing waves within the cross-sectional pattern shape, and are consequently also preferred.

Furthermore, in the present invention, if the component (B) includes an onium salt-based acid generator with a perfluoroalkylsulfonate ion of 3 or 4 carbon atoms as the anion (hereafter abbreviated as a C3 to C4 onium salt), then the mask linearity improves, meaning mask patterns of various sizes can be reproduced faithfully, and this is very desirable. Furthermore, such C3 to C4 onium salts also exhibit a favorable proximity effect, and excellent DOF and exposure margin. The alkyl group of the perfluoroalkylsulfonate may be either a straight-chain or branched group, although a straight-chain group is preferred.

In those cases where a C3 to C4 onium salt is added as the component (B), the quantity of the C3 to C4 onium salt within the component (B) is preferably within a range from 50 to 100% by weight.

Furthermore, in those cases where a C3 to C4 onium salt is added as the component (B), an onium salt-based acid generator with a perfluoroalkylsulfonate ion of one carbon atom as the anion (hereafter abbreviated as a C l onium salt) is preferably also added.

Of these onium salts, triphenylsulfonium salts (wherein the phenyl groups may also contain substituents) are resistant to decomposition and unlikely to generate organic gases, and are consequently preferred. The quantity of such triphenylsulfonium salts relative to the total quantity of the component (B) is preferably within a range from 30 to 100 mol%, and even more preferably from 50 to 100 mol%. Mixtures of an onium salt and a diazomethane enable improvements in the circularity of resist hole patterns and suppression of standing waves within the cross-sectional pattern shape, without losing the favorable depth of focus and exposure margin characteristics described above, and are consequently preferred. In the case of such mixtures, the quantity of the onium salt within the mixture is preferably within a range from 20 to 90 mol%, and even more preferably from 30 to 70 mol%.

Of the above onium salts, iodonium salts may give rise to organic gases containing iodine.

Furthermore, of the triphenylsulfonium salts, triphenylsulfonium salts represented by the general formula (V) shown below, which incorporate a perfluoroalkylsulfonate ion as the anion, provide improved levels of sensitivity, and are consequently preferred. 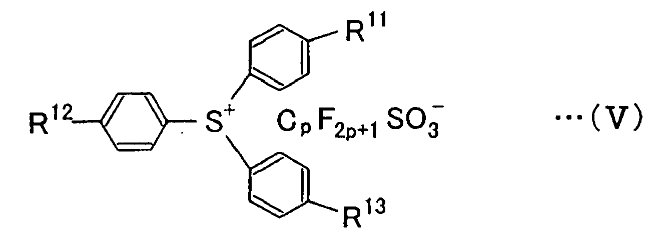 [wherein, R¹¹, R¹², and R¹³ each represent, independently, a hydrogen atom, a lower alkyl group of 1 to 8, and preferably 1 to 4, carbon atoms, or a halogen atom such as a chlorine, fluorine, or bromine atom; and p represents an integer from 1 to 12, and preferably from 1 to 8, and even more preferably from 1 to 4]

The component (B) can be used either alone, or in combinations of two or more different compounds.

The quantity used of the component (B) is typically within a range from 0.5 to 30 parts by weight, and preferably from 1 to 10 parts by weight, per 100 parts by weight of the component (A). At quantities less than 0.5 parts by weight, pattern formation does not proceed satisfactorily, whereas if the quantity exceeds 30 parts by weight, achieving a uniform solution becomes difficult, and there is a danger of a deterioration in the storage stability.

### <Component (C)>

In addition to the component (A) and the component (B) described above, a positive resist composition of the present invention preferably also includes a dissolution inhibitor (C).

As the component (C), any of the conventional dissolution inhibitors already used in three-component chemically amplified resist compositions, in which at least one hydrogen atom of a phenolic hydroxyl group or a carboxyl group has been substituted with an acid dissociable, dissolution inhibiting group, can be used. As the dissolution inhibitor, a compound with a weight average molecular weight of no more than 1,000 is preferably used.

Examples of compounds containing a phenolic hydroxyl group which can be converted to dissolution inhibitors include polyphenol compounds containing from 3 to 5 phenolic hydroxyl groups, such as triphenylmethane-based compounds, bis(phenylmethyl)diphenylmethane-based compounds and 1,1-diphenyl-2-biphenylethane-based compounds which contain hydroxyl groups as nuclear substituents. Furthermore, dimers through hexamers obtained by formalin condensation of at least one phenol selected from the group consisting of phenol, m-cresol, and 2,5-xylenol can also be used.

Furthermore, examples of carboxyl compounds in which the carboxyl group can be protected with an acid dissociable, dissolution inhibiting group include biphenylcarboxylic acid, naphthalene (di)carboxylic acid, benzoylbenzoic acid, and anthracenecarboxylic acid.

Examples of the acid dissociable, dissolution inhibiting group within these dissolution inhibitors include tertiary alkyloxycarbonyl groups such as a tert-butoxycarbonyl group or tert-amyloxycarbonyl group; tertiary alkyl groups such as a tert-butyl group or tert-amyl group; tertiary alkoxycarbonylalkyl groups such as a tert-butoxycarbonylmethyl group or tert-butoxycarbonylethyl group; lower alkoxyalkyl groups such as a 1-ethoxyethyl group, 1-isopropoxyethyl group, 1-methoxy-1-methylethyl group, 1-methoxypropyl group, or 1-n-butoxyethyl group; and cyclic ether groups such as a tetrahydropyranyl group or tetrahydrofuranyl group. Tertiary alkoxycarbonylalkyl groups are particularly preferred, as they generate a carboxylic acid on dissociation of the tertiary alkoxy group, which provides superior contrast.

In those cases where a dissolution inhibitor (C) is included in a positive resist composition of the present invention, the quantity of the dissolution inhibitor is preferably within a range from 1 to 40% by weight, and even more preferably from 10 to 30% by weight, relative to the quantity of the component (A). If the quantity of the dissolution inhibitor is less than this range, then the effect of adding the compound does not manifest adequately, whereas if the quantity is too large, an undesirable deterioration in the pattern shape or lithography characteristics can occur.

### <Organic Solvent>

A positive resist composition of the present invention is preferably produced by dissolving the aforementioned component (A) and component (B), and preferably the aforementioned component (C), together with any other optional components described below, in an organic solvent.

The organic solvent may be any solvent capable of dissolving the various components to generate a uniform solution, and one or more solvents selected from known materials used as the solvents for conventional chemically amplified resists can be used.

Specific examples of the solvent include ketones such as acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol. diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate, methyl acetate, ethyl acetate, butyl acetate, methyl pyruvate, ethyl pyruvate, methyl methoxypropionate, and ethyl ethoxypropionate. These organic solvents can be used alone, or as a mixed solvent of two or more different solvents.

In the present invention, a mixed solvent containing propylene glycol monomethyl ether (PGME) and another solvent with a higher boiling point than PGME is particularly preferred. Such a solvent enables improvements in the resist pattern shape characteristics such as the line edge roughness and the line-width roughness (irregularity in the line width from left to right). Furthermore, the depth of focus (DOF) for contact holes also broadens.

Line edge roughness refers to non-uniform irregularities in the line side walls. The 3σ value is determined as a measure of the line edge roughness of a line and space pattern. The 3σ value is determined by measuring the resist pattern width of the sample at 32 positions using a measuring SEM (S-9220, a brand name, manufactured by Hitachi, Ltd.), and calculating the value of 3 times the standard deviation (3σ) from these measurement results. The smaller this 3σ value is, the lower the level of roughness, indicating a resist pattern with a uniform width.

As the solvent with a higher boiling point than PGME, solvents from amongst those listed above for which the boiling point exceeds the 120°C boiling point of PGME can be used, and solvents for which the boiling point is at least 20°C higher, and even more preferably at least 25°C higher, than that of PGME are particularly desirable. There are no particular restrictions on the upper limit for this boiling point, but boiling points of no more than approximately 200°C are preferred. Specific examples of this type of solvent include propylene glycol monomethyl ether acetate (boiling point: 146°C), EL (boiling point: 155°C), and γ-butyrolactone (boiling point: 204°C). Of these, EL is particularly preferred. The quantity of PGME within the mixed solvent preferably accounts for 10 to 60% by weight, and even more preferably 20 to 40% by weight of the total solvent. Quantities within this range produce superior effects.

### <Component (D)>

In a positive resist composition of the present invention, in order to improve the resist pattern shape and the post exposure stability of the latent image formed by the pattern-wise exposure of the resist layer, a nitrogen-containing organic compound (D) (hereafter referred to as the component (D)) can also be added as an optional component.

A multitude of these nitrogen-containing organic compounds have already been proposed, and any of these known compounds can be used as the component (D), although an amine, and particularly a secondary aliphatic amine or tertiary aliphatic amine, is preferred.

Specific examples of the component (D) include alkyl amines such as trimethylamine, diethylamine, triethylamine, di-n-propylamine, tri-n-propylamine, tripentylamine, tri-n-heptylamine, tri-n-octylamine, di-n-heptylamine, di-n-octylamine, and tri-n-dodecylamine; and alkylalcohol amines such as diethanolamine, triethanolamine, diisopropanolamine, triisopropanolamine, di-n-octanolamine, and tri-n-octanolamine. These compounds may be used alone, or in combinations of two or more different compounds.

These compounds are typically added in a quantity within a range from 0.01 to 5.0 parts by weight per 100 parts by weight of the component (A).

### <Component (E)>

Furthermore, in order to prevent any deterioration in sensitivity caused by the addition of the aforementioned component (D), and improve the resist pattern shape and the post exposure stability of the latent image formed by the pattern-wise exposure of the resist layer, an organic carboxylic acid, or a phosphorus oxo acid or derivative thereof (E) (hereafter referred to as the component (E)) can also be added as another optional component (E). Either one, or both of the component (D) and the component (E) can be used.

Examples of suitable organic carboxylic acids include malonic acid, citric acid, malic acid, succinic acid, benzoic acid, and salicylic acid.

Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate, and dibenzyl phosphonate; and phosphinic acid or derivatives thereof such as esters, including phosphinic acid and phenylphosphinic acid, and of these, phosphonic acid is particularly preferred.

The component (E) is typically used in a quantity within a range from 0.01 to 5.0 parts by weight per 100 parts by weight of the component (A).

Other miscible additives can also be added to a positive resist composition of the present invention according to need, and examples include additive resins for improving the properties of the resist film, surfactants for improving the ease of application, plasticizers, stabilizers, colorants, and halation prevention agents.

The cause of the deterioration in the shape characteristics observed for chemically amplified resists that use a silicone resin is thought to be due to the fact that silicone resins themselves tend to have poor heat resistance, meaning the base resin of the resist composition is prone to damage during the heating of the PEB step used for dissociating the acid dissociable, dissolution inhibiting groups. For example, if the heating temperature during PEB is too low, then the dissociation of the acid dissociable, dissolution inhibiting group does not proceed satisfactorily, making it impossible to obtain a resist pattern of the desired shape, and consequently, the PEB temperature must be increased to some extent, but if the PEB temperature exceeds the heat resistant temperature of the resist composition, then the resist pattern begins to deform (flow), causing a deterioration in the cross-sectional shape.

In contrast, according to a positive resist composition of the present invention, a resist pattern with excellent shape characteristics, including line edge roughness and cross-sectional shape, can be realized. Particularly in those cases where a positive resist composition according to the first aspect of the present invention is used, the roughness of a hole pattern when viewed from above is significantly reduced, and the shape characteristics (circularity) are favorable, meaning the composition is ideal for hole-shaped resist patterns. In a positive resist composition of the present invention, by including the aforementioned structural units (a3) in the base silsesquioxane resin (A1), a level of heat resistance is obtained that is superior to that of a silsesquioxane resin containing no structural units (a3), and it is thought that this enables favorable shape characteristics to be obtained with good stability.

Furthermore, a positive resist composition of the first aspect also exhibits a high level of resolution, a broad depth of focus, and a favorable exposure margin. Including the structural units (a1) enables a particularly effective improvement in the exposure margin.

Furthermore, by using a comparatively low prebake temperature of approximately 70 to 90°C, the occurrence of white edge can be improved effectively.

A major characteristic feature of a positive resist composition of the second aspect of the present invention is the acid dissociable, dissolution inhibiting groups of the structural units (a2') that are introduced into the resin component (A2), and the introduction of these groups results in a favorable exposure margin and a favorable depth of focus, and also produces superior levels of line edge roughness and rectangularity of the cross-sectional shape.

In other words, the acid dissociable, dissolution inhibiting groups of the structural units (a2') dissociate more readily than conventional tertiary alkyloxycarbonyl groups, tertiary alkyl groups, tertiary alkoxycarbonylalkyl groups, or cyclic ether groups, and as a result, the resolution, shape characteristics, exposure margin, and depth of focus for the resulting resist pattern can all be improved.

Chain-like lower alkoxyalkyl groups that contain no cyclic alkyl groups, such as 1-ethoxyethyl groups and the like, are known as acid dissociable, dissolution inhibiting groups that are able to dissociate even in comparatively weak acid, and because they dissociate readily, the resolution, exposure margin, and depth of focus for the resulting resist pattern are very favorable, but such resins tend to be prone to pattern thickness loss during developing, and the resist pattern is prone to losing rectangularity. In contrast, the acid dissociable, dissolution inhibiting group of the structural unit (a2') is an acetal group with a cyclic alkyl group, and consequently it dissociates relatively readily, and also provides a powerful dissolution inhibiting effect prior to dissociation. Accordingly, a positive resist composition of the present invention containing the structural units (a2') not only exhibits excellent shape characteristics, exposure margin, and depth of focus for the resulting resist pattern, but also suffers minimal shape deterioration during developing, enabling the generation of a resist pattern with favorable shape characteristics and excellent rectangularity. A positive resist composition of this aspect of the present invention is particularly suited to the formation of line and space patterns and trench patterns.

A positive resist composition of the present invention can be used particularly favorably in a process for patterning a support using a two-layer resist.

As follows is a description of a resist laminate that can be used as a two-layer resist.

### [Resist Laminate]

A resist laminate of the present invention includes a lower organic layer, which is insoluble in the alkali developing solution but can be dry etched, and an upper resist layer formed from a positive resist composition of the present invention laminated on top of a support.

As the support, conventional materials can be used without any particular restrictions, and suitable examples include substrates for electronic componentry, as well as substrates on which a predetermined wiring pattern has already been formed.

Specific examples of suitable substrates include metal-based substrates such as silicon wafers, copper, chrome, iron, and aluminum, as well as glass substrates.

Suitable materials for the wiring pattern include copper, aluminum, nickel, and gold.

The lower organic layer is an organic film which is insoluble in the alkali developing solution used for post-exposure developing, but can be etched by conventional dry etching.

With this type of lower organic layer, first, normal photolithography techniques are used to expose and then alkali-develop only the upper resist layer, thereby forming a resist pattern, and by then using this resist pattern as a mask to conduct dry etching of the lower organic layer, the resist pattern of the upper resist layer is transferred to the lower organic layer. As a result, a resist pattern with a high aspect ratio can be formed without pattern collapse of the resist pattern.

The organic film material for forming the lower organic layer does not necessarily require the photosensitivity needed for the upper resist layer, and can use the types of resists and resins typically used as a base material in the production of semiconductor elements and liquid crystal display elements.

Furthermore, because the resist pattern of the upper resist layer must be transferred to the lower organic layer, the lower organic layer should preferably be formed from a material that is able to be etched by oxygen plasma etching.

As this material, materials containing at least one resin selected from a group consisting of novolak resins, acrylic resins, and soluble polyimides as the primary component are preferred, as they are readily etched by oxygen plasma treatment, and also display good resistance to fluorocarbon-based gases, which are used in subsequent processes for tasks such as etching the silicon substrate.

Of these materials, novolak resins, and acrylic resins containing an alicyclic region or aromatic ring on a side chain are cheap, widely used, and exhibit excellent resistance to the dry etching of subsequent processes, and are consequently preferred.

As the novolak resin, any of the resins typically used in positive resist compositions can be used, and positive resists for i-line or g-line radiation containing a novolak resin as the primary component can also be used.

A novolak resin is a resin obtained, for example, from an addition condensation of an aromatic compound containing a phenolic hydroxyl group (hereafter, simply referred to as a phenol) and an aldehyde, in the presence of an acid catalyst.

Examples of the phenol used include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol, p-phenylphenol, resorcinol, hydroquinone, hydroquinone monomethyl ether, pyrogallol, fluoroglycinol, hydroxydiphenyl, bisphenol A, gallic acid, gallic esters, α-naphthol, and β-naphthol.

Furthermore, examples of the aldehyde include formaldehyde, furfural, benzaldehyde, nitrobenzaldehyde, and acetaldehyde.

There are no particular restrictions on the catalyst used in the addition condensation reaction, and suitable acid catalysts include hydrochloric acid, nitric acid, sulfuric acid, formic acid, oxalic acid, and acetic acid.

The weight average molecular weight of the novolak resin is typically within a range from 3,000 to 10,000, and preferably from 6,000 to 9,000, and most preferably from 7,000 to 8,000. If the weight average molecular weight is less than 3,000, then the resin may sublime when baked at high temperatures, whereas if the weight average molecular weight exceeds 10,000, the resin tends to become more difficult to dry etch, which is undesirable.

Novolak resins for use in the present invention can use commercially available resins. One suitable example is TBLC-100 (product name, manufactured by Tokyo Ohka Kogyo Co., Ltd.). Novolak resins with a weight average molecular weight (Mw) of 5,000 to 50,000, and preferably from 8,000 to 30,000, in which the quantity of low molecular weight materials with a molecular weight of no more than 500, and preferably no more than 200, as measured by gel permeation chromatography, is no more than 1% by weight, and preferably 0.8% by weight or less, are preferred. The low molecular weight fraction is preferably as small as possible, and is most preferably 0% by weight.

The low molecular weight materials with a molecular weight of no more than 500 are detected as a low molecular weight fraction of molecular weight 500 or less during GPC analysis using polystyrene standards. These low molecular weight materials with a molecular weight of no more than 500 include unpolymerized monomers, and low polymerization degree materials, which vary depending on the molecular weight, but include, for example, materials produced by the condensation of 2 to 5 phenol molecules with an aldehyde.

The quantity (weight %) of this low molecular weight fraction with a molecular weight of no more than 500 is measured by graphing the results of the above GPC analysis, with the fraction number across the horizontal axis and the concentration along the vertical axis, and then determining the ratio (%) of the area under the curve within the low molecular weight fraction for molecular weights of no more than 500, relative to the area under the entire curve.

By ensuring that the Mw of the novolak resin is no more than 50,000, more favorable filling characteristics can be obtained for substrates with very fine indentations. Furthermore, by ensuring that the molecular weight is at least 5,000, a superior level of resistance to etching by fluorocarbon-based gases and the like can be achieved.

Furthermore, ensuring that the quantity of low molecular weight materials with a molecular weight of no more than 500 is no more than 1% by weight produces more favorable filling characteristics for substrates with very fine indentations. The reason that such a reduction in the low molecular weight fraction should improve the filling characteristics remains unclear, although it is surmised that it is a reflection of the reduced polydispersity.

As the acrylic resin, any of the resins typically used in positive resist compositions can be used, and suitable examples include acrylic resins containing structural units derived from a polymerizable compound with an ether linkage, and structural units derived from a polymerizable compound containing a carboxyl group.

Examples of the polymerizable compound containing an ether linkage include (meth)acrylate derivatives containing both an ether linkage and an ester linkage such as 2-methoxyethyl (meth)acrylate, methoxytriethylene glycol (meth)acrylate, 3-methoxybutyl (meth)acrylate, ethylcarbitol (meth)acrylate, phenoxypolyethylene glycol (meth)acrylate, methoxypolypropylene glycol (meth)acrylate, and tetrahydrofurfuryl (meth)acrylate. These compounds can be used either alone, or in combinations of two or more different compounds.

Examples of the polymerizable compound containing a carboxyl group include monocarboxylic acids such as acrylic acid, methacrylic acid, and crotonic acid; dicarboxylic acids such as maleic acid, fumaric acid, and itaconic acid; and compounds containing both a carboxyl group and an ester linkage such as 2-methacryloyloxyethylsuccinic acid, 2-methacryloyloxyethylmaleic acid, 2-methacryloyloxyethylphthalic acid, and 2-methacryloyloxyethylhexahydrophthalic acid, although of these, acrylic acid and methacrylic acid are preferred. These compounds can be used either alone, or in combinations of two or more different compounds.

The soluble polyimide refers to polyimides that can be converted to liquid form in the type of organic solvents described above.

In a resist laminate of the present invention, giving due consideration to the ideal balance between the targeted aspect ratio and the throughput, which is affected by the dry etching time required for the lower organic layer, the combined thickness of the upper resist layer and the lower organic layer is preferably a total of no more than 15 µm, and is preferably no more than 5 µm. There are no particular restrictions on the lower limit for this combined thickness, although values of at least 0.1 µm are preferred, and values of 0.35 µm or greater are even more desirable.

The thickness of the upper resist layer is preferably within a range from 50 to 1,000 nm, and even more preferably from 50 to 800 nm, and most preferably from 100 to 500 nm. By ensuring that the thickness of the upper resist layer falls within this range, the resist pattern can be formed with a high level of resolution, while a satisfactory level of resistance to dry etching can also be achieved.

The thickness of the lower organic layer is preferably within a range from 300 to 20,000 nm, and even more preferably from 300 to 8,000 nm, and most preferably from 400 to 5,000 nm. By ensuring that the thickness of the lower organic layer falls within this range, a resist pattern with a high aspect ratio can be formed, while a satisfactory level of etching resistance to subsequent substrate etching can also be ensured.

In the present invention, the thickness of the upper resist layer can be set within a range from 50 to 1,000 nm, and the thickness of the lower organic layer set within a range from 300 to 20,000 nm, and even with this type of thick film, the pattern width can be kept very small, and a high aspect ratio pattern (the lower organic layer pattern) can be formed. As a result, the present invention is ideally suited to fields that require microfabrication, including electronic wiring, magnetic film patterning, and other micromachining.

The resist laminate of the present invention includes both laminates in which a resist pattern has been formed in the upper resist layer and the lower organic layer, as well as laminates in which no resist pattern has been formed.

In a resist laminate in which a resist pattern has been formed, a high aspect ratio pattern is preferably able to be formed without any pattern collapse. The higher the aspect ratio of the pattern becomes, the more precisely a fine pattern is able to formed within the support.

In this description, the term aspect ratio refers to the ratio of the height y of the lower organic layer relative to the pattern width x of the resist pattern (namely, y/x). The pattern width x of the resist pattern is the same as the pattern width following transfer of the pattern to the lower organic layer.

In those cases where the resist pattern is a line-shaped pattern such as a line and space pattern or an isolated line pattern, the pattern width refers to the width of a raised portion (a line). In those cases where the resist pattern is a hole pattern, the pattern width refers to the inner diameter of a formed hole.

Furthermore, in those cases where the resist pattern is a circular dot pattern, the pattern width is the diameter of a dot. These pattern widths all refer to the widths at the bottom of the pattern.

According to a positive resist composition of the present invention, a high aspect ratio pattern can be provided with comparative ease. In the case of dot patterns or isolated line patterns, dot patterns with an aspect ratio of at least 8 but no more than 20, which have been impossible to achieve within a lower organic layer of film thickness 2.5 µm using conventional resist compositions, can be realized. In the case of trench patterns, trench patterns with an aspect ratio of at least 10 but no more than 20, which have been impossible to achieve within a lower organic layer of film thickness 2.5 µm using typical resist compositions, can be achieved. In both these cases, the maximum aspect ratio achievable using conventional resist compositions has been approximately 5.

### [Process for Forming Resist Pattern]

A process for forming a resist pattern using this type of resist laminate can be conducted, for example, in the manner described below.

First, a resist composition or resin solution for forming the lower organic layer is applied to the top of a substrate such as a silicon wafer using a spinner or the like, and a prebake treatment is then performed, preferably at a temperature of 200 to 300°C, for a period of 30 to 300 seconds, and preferably for 60 to 180 seconds, thus forming a lower organic layer.

An organic or inorganic anti-reflective film may also be provided between the lower organic layer and the upper resist layer.

Next, a positive resist composition of the present invention is applied to the surface of the lower organic layer using a spinner or the like, and a prebake treatment is then performed at a temperature of 70 to 130°C for a period of 40 to 180 seconds, and preferably for 60 to 90 seconds, thus forming an upper resist layer and completing preparation of a resist laminate of the present invention.

This resist laminate is then selectively exposed with a KrF exposure apparatus or the like, by irradiating KrF excimer laser light through a desired mask pattern, and PEB (post exposure baking) is then conducted under temperature conditions of 70 to 130°C for 40 to 180 seconds, and preferably for 60 to 90 seconds.

Subsequently, the resist laminate is developed using an alkali developing solution such as an aqueous solution of tetramethylammonium hydroxide with a concentration of 0.05 to 10% by weight, and preferably from 0.05 to 3% by weight. In this manner, a resist pattern (I) that is faithful to the mask pattern can be formed in the upper resist layer.

As the light source used for the exposure, a KrF excimer laser or electron beam is particularly effective, but other light sources such as an ArF excimer laser, a F₂ excimer laser, EUV (extreme ultraviolet), VUV (vacuum ultraviolet), electron beam, X-ray or soft X-ray radiation can also be used effectively. In those cases where an electron beam is used, selective electron beam irradiation may be conducted via a mask, or direct patterning may also be used.

A positive resist composition and resist laminate of the present invention exhibit superior levels of line edge roughness and cross-sectional shape rectangularity, and suffer no problems of pattern collapse, even when a very fine pattern is formed, and consequently are ideally suited to high level microfabrication using an electron beam.

Next, the obtained resist pattern (I) is used as a mask pattern for conducting dry etching of the lower organic layer, thereby forming a resist pattern (II) in the lower organic layer.

As the dry etching method, conventional methods including chemical etching such as down-flow etching or chemical dry etching; physical etching such as sputter etching or ion beam etching; or chemical-physical etching such as RIE (reactive ion etching) can be used.

The most typical type of dry etching is parallel plate RIE. In this method, first, the resist laminate is placed inside the RIE apparatus chamber, and the required etching gas is introduced. A high frequency voltage is then applied within the chamber, between an upper electrode and the resist laminate holder which is positioned parallel to the electrode, and this causes the generation of a gas plasma. The plasma contains charged particles such as positive and negative ions and electrons, as well as electrically neutral active seeds. As these etching seeds adsorb to the lower organic layer, a chemical reaction occurs, and the resulting reaction product breaks away from the surface and is discharged externally, causing the etching to proceed.

As the etching gas, oxygen or sulfur dioxide or the like are suitable, although oxygen is preferred, as oxygen plasma etching provides a high level of resolution, the silsesquioxane resin (A1) of the present invention displays favorable etching resistance to oxygen plasma, and oxygen plasma is also widely used.

In this manner, a resist pattern that includes the laminated resist pattern (I) and resist pattern (II) is obtained, and by using this laminated resist pattern as a mask for etching, a fine pattern can be formed within the support.

As the etching method for this etching of the support, an etching method that uses a halogen-based gas is particularly preferred.

According to a process for forming a resist pattern according to the present invention, because the resist pattern is formed using a laminate produced by laminating a lower organic layer and an upper resist layer, the thickness of the upper resist layer can be reduced even in those cases where a pattern with a high aspect ratio is to be formed. Normally, a reduction in the film thickness of the upper resist layer improves the resolution, but tends to cause a marked increase in line edge roughness or hole pattern edge roughness (hereafter referred to jointly as "edge roughness"). However, the resist composition used for forming the upper resist layer in the present invention exhibits favorable alkali solubility even when formed as a thin film, meaning the occurrence of edge roughness can be reduced.

Furthermore, the silsesquioxane resin (A1) or (A2) incorporated within the component (A) exhibits superior heat resistance, meaning even after heating steps, a favorable resist pattern can be obtained. Because the silsesquioxane resins (A1) and (A2) contain the structural units (a2) and (a2') respectively, each of which contains an acid dissociable, dissolution inhibiting group, sufficient heat must be applied in the PEB step to cause dissociation of these acid dissociable, dissolution inhibiting groups, but even under this type of heating, thermal deformation of the resist pattern is prevented.

The shape of the resist pattern formed using such a process has a high aspect ratio, suffers no pattern collapse, and provides a high degree of verticalness.

Furthermore, in order to effectively prevent the occurrence of white edges, the heating temperature during the prebake is preferably set to approximately 70 to 90°C.

### [Resist Pattern Narrowing Step]

A positive resist composition of the present invention can also be used favorably in a process for forming a resist pattern that includes a narrowing step.

A narrowing step is a step in which, following the steps of exposure and developing for forming a resist pattern on a substrate, the resist pattern is coated with a water-soluble resin coating and then subjected to a heat treatment, thereby narrowing the spacing within the resist pattern, or narrowing the hole diameter of a hole pattern. This narrowing step enables the formation of an even finer resist pattern.

More specifically, a resist pattern (I) is first formed in the upper resist layer using the sequence described above, and a coating formation agent containing a water-soluble polymer or the like is then applied to the surface of the resist pattern (I), preferably forming a water-soluble resin coating across the entire surface of the resist pattern, thus forming a coated resist pattern. Following application of the coating formation agent, a prebake may be conducted at a temperature of 80 to 120°C for a period of 30 to 90 seconds. The application of the coating agent can be conducted using a known method used in the formation of conventional resist layers and the like. In other words, the aqueous solution of the coating formation agent can be applied to the substrate using a spinner or the like.

Subsequently, the thus obtained coated resist pattern is subjected to heat treatment, causing the water-soluble resin coating to undergo heat shrinkage. As a result of this heat shrinkage of the water-soluble resin coating, the side walls of the resist patterns (I) adjacent to the water-soluble resin coating are pulled together, thereby narrowing the spacing between patterns.

This photoresist pattern spacing determines the final pattern size (the hole diameter within a hole pattern, the width within a line and space pattern, or the width of a trench pattern), and consequently the heat shrinkage of the water-soluble resin coating is able to narrow the pattern size, enabling a further miniaturization of the pattern.

The heating temperature is set to the temperature required to achieve shrinkage of the water-soluble resin coating, and there are no particular restrictions on this temperature provided satisfactory narrowing of the pattern size can be achieved, although the heating is preferably conducted at a temperature that is lower than the softening point of the resist pattern. Conducting the heat treatment at this type of temperature is extremely beneficial, as it enables a pattern with a good profile to be formed more effectively, and also reduces the pitch dependency of the degree of narrowing within the substrate plane, that is, the degree to which the level of narrowing is dependent on the pattern size within the substrate plane.

The "softening point of the resist pattern" refers to the temperature at which the photoresist pattern formed on the substrate begins to flow spontaneously during heat treatment of the substrate. The softening point of the resist pattern varies depending on the resist composition used to form the resist pattern. Taking into consideration the softening points of the various resist compositions used in current lithography techniques, a preferred heat treatment is typically conducted at a temperature within a range from 80 to 160°C, at a temperature that does not cause fluidization of the resist, for a period of 30 to 90 seconds.

Furthermore, the thickness of the water-soluble resin coating is preferably either approximately equal to the height of the photoresist pattern, or of a height sufficient to cover the photoresist pattern, and is typically within a range from 0.1 to 0.5 µm.

Subsequently, the heat-shrunk water-soluble resin coating, which still remains on the pattern, is removed by washing with an aqueous solvent, and preferably with pure water, for 10 to 60 seconds. The water-soluble resin coating is easily removed by washing with water, and is able to be completely removed from the substrate and the resist pattern.

Using the thus obtained resist pattern (I) as a mask pattern, dry etching of the lower organic layer is then conducted in the manner described above, thus forming a resist pattern (II) in the lower organic layer.

There are no particular restrictions on the water-soluble polymer contained within the coating formation agent used to form the water-soluble resin coating, provided the polymer is soluble in water at room temperature, although resins that include structural units derived from at least one monomer which acts as a proton donor, and structural units derived from at least one monomer which acts as a proton acceptor are ideal. By using this type of resin, volumetric shrinkage can be favorably carried out by heating.

This type of water-soluble polymer may be a copolymer containing structural units derived from at least one monomer which acts as a proton donor, and structural units derived from at least one monomer which acts as a proton acceptor, or a mixture of a polymer with structural units derived from at least one monomer which acts as a proton donor, and a polymer with structural units derived from at least one monomer which acts as a proton acceptor, although when co-solubility is taken into consideration, a copolymer is preferred.

From an industrial viewpoint, this water-soluble polymer is preferably an acrylic-based polymer, a vinyl-based polymer, a cellulose derivative, an alkylene glycol-based polymer, a urea-based polymer, a melamine-based polymer, an epoxy-based polymer or an amide-based polymer.

Of the above polymers, a composition that includes at least one polymer selected from a group consisting of alkylene glycol-based polymers, cellulose-based polymers, vinyl-based polymers and acrylic-based polymers is preferred, and acrylic resins are the most preferred as they also offer simple pH adjustment. In addition, using a copolymer of an acrylic-based polymer, and another non-acrylic water-soluble polymer is preferred, as such copolymers enable efficient narrowing of the photoresist pattern size, while maintaining the shape of the photoresist pattern during the heat treatment. The water-soluble polymer may be either a single polymer, or a mixture of two or more polymers.

The monomer which acts as a proton donor is preferably acrylamide or N-vinylpyrrolidone.

The monomer which acts as a proton acceptor is preferably acrylic acid or the like.

A water-soluble polymer that includes polymer structural units derived from N-vinylpyrrolidone as the proton donor monomer, and polymer structural units derived from acrylic acid as the proton acceptor monomer is particularly preferred.

The coating formation agent is preferably used in the form of an aqueous solution with a concentration of 3 to 50% by weight, and even more preferably from 5 to 20% by weight. If the concentration is less than 3% by weight, a satisfactory coating may not be formed on the substrate, whereas at concentrations exceeding 50% by weight, not only does increasing the concentration not produce an equivalent improvement in the desired effects, but the handling of the agent also becomes more difficult.

As described above, the coating formation agent is usually used in the form of an aqueous solution using water as the solvent, although a mixed solvent of water and an alcohol-based solvent could also be used. Examples of this alcohol-based solvent include monovalent alcohols such as methyl alcohol, ethyl alcohol, propyl alcohol, and isopropyl alcohol. The alcohol-based solvent is added to the water in quantities of no more than 30% by weight.

### [Dual Damascene Process]

Furthermore, a positive resist composition of the present invention can also be used favorably as the chemically amplified positive resist used in the production of a semiconductor device by a via-first dual damascene process, and is particularly effective in preventing the generation of resist poisoning. This process is described below in more detail.

With the ongoing miniaturization of semiconductor devices, a shift is now taking place from conventional processes that use reactive ion etching (RIE) techniques to form A1 wiring, to processes that use damascene techniques to from Al-Cu wiring or Cu wiring.

In damascene technology, the formation of two types of etched portions, namely via holes and wiring trenches, is referred to as a dual damascene process.

Dual damascene processes include trench-first processes in which the wiring trenches are formed first, and via-first processes in which the via holes are formed first (see "Cu Wiring Technology: Recent Developments", edited by Katsuro Fukozu, published by Realize, May 30, 1998, pp. 202 to 205).

In a via-first process for producing a semiconductor device, a substrate is first prepared, for example by sequentially laminating a first interlayer insulating layer, an etching stopper layer, and a second interlayer insulating layer on top of a base material. The chemically amplified positive resist composition is then applied and exposed in accordance with a predetermined pattern, thereby converting the exposed portions to an alkali-soluble state, these exposed portions are removed using an alkali developing solution, and the lower layers beneath the portions no longer covered by the resist pattern are then etched, thus forming via holes that pass through the first interlayer insulating layer, the etching stopper layer, and the second interlayer insulating layer. Subsequently, another chemically amplified positive resist composition is then applied and exposed, thereby converting the exposed portions to an alkali-soluble state, these exposed portions are removed using an alkali developing solution, and the lower layer beneath the portions no longer covered by the resist pattern is then etched so as to widen the trench width of the via holes formed in the second interlayer insulating layer, thus forming wiring trenches. Finally, the via holes formed in the first interlayer insulating layer and the etching stopper layer, and the wiring trenches formed in the second interlayer insulating layer are embedded with copper, thereby completing formation of wiring with a substantially T-shaped cross section.

### [Pattern Formation for Processing Magnetic Films]

A positive resist composition of the present invention exhibits excellent lithography characteristics and resist pattern shape characteristics. Accordingly, the resist composition can be used favorably for forming a resist pattern for generating a magnetic film pattern, which requires high level microfabrication.

In other words, a positive resist composition of the present invention is ideal for forming a resist layer on top of a magnetic film provided on top of a substrate, or on top of a metallic oxidation prevention film provided on top of such a magnetic film.

Specific applications include the formation of the read portion or write portion of a magnetic head, as described below.

When conducting pattern formation of a magnetic film, a resist pattern for conducting the processing of the magnetic film is first formed. When forming this resist pattern for processing the magnetic film, a two-layer resist process is preferably used, as such processes enable more ready formation of a high aspect ratio resist pattern.

Formation of a resist pattern for magnetic film processing using a two-layer resist process can be conducted by using a magnetic film material containing a magnetic film as the substrate described in the above section entitled "Process for Forming Resist Pattern", and then forming a resist laminate of the present invention as described above, and forming resist patterns (I) and (II) within this resist laminate.

The magnetic film material uses either a material containing a substrate and a magnetic film formed thereon, or a material that also includes a metallic oxidation prevention film formed on top of the magnetic film.

Specifically, formation of a resist pattern for processing a magnetic film can be conducted using the steps (1) to (5) described below.
(1) A step of forming a lower organic layer on top of either a magnetic film provided on top of a substrate, or on top of a metallic oxidation prevention film provided on top of such a magnetic film, and then forming an upper resist layer from a positive resist composition of the present invention on top of the lower organic layer, thus completing preparation of a resist laminate, (2) a step of conducting selective exposure of the resist laminate, (3) a step of conducting post exposure baking (PEB) of the selectively exposed resist laminate, (4) a step of conducting alkali developing of the exposed and baked resist laminate, thereby forming a resist pattern (I) in the upper resist layer, and (5) a step of conducting dry etching of the lower organic layer using the resist pattern (I) as a mask, thus forming a resist pattern (II) in the lower organic layer.

Preferred conditions for the formation of the lower organic layer, the formation of the upper resist layer, the selective exposure, the post exposure baking, the developing treatment, and the etching are the same as those described above in the section entitled "Process for Forming Resist Pattern".

In this manner, a resist pattern for processing the magnetic film that includes the laminated resist pattern (I) and resist pattern (II) can be obtained, and by subsequently using these patterns as a mask for conducting etching, a fine pattern with a high aspect ratio can be formed in the magnetic film.

For example, the principal component of the magnetic film may be one or more of iron, cobalt, and nickel.

Furthermore, examples of the principal component of the metallic oxidation prevention film provided on top of the magnetic film include one or more of tantalum and aluminum oxide (Al₂O₃).

A principal component refers to a component that accounts for at least 50% by weight, and preferably 80% by weight or greater of the film.

Components other than the principal component within the magnetic film or the oxidation prevention film can be selected appropriately from conventional materials typically used within magnetic films or metallic oxidation prevention films laminated on top of such magnetic films.

When forming a magnetic film on a substrate, the magnetic film is preferably formed as the layer in direct contact with the substrate, and in those cases where a metallic oxidation prevention film is formed, this oxidation prevention film is preferably formed directly on top of the magnetic film.

There are no particular restrictions on the thickness of the magnetic film or the oxidation prevention film.

The substrate uses, for example, a silicon substrate.

### [Micromachining]

A positive resist composition of the present invention is ideal for fields that require microfabrication using a resist pattern with a high aspect ratio, such as micromachining applications, including the aforementioned applications that use a magnetic film.

Micromachining is a three dimensional ultra fine processing technique that utilizes lithography techniques, and is used in the production of so-called MEMS, which are high level microsystems containing a variety of integrated microstructures such as sensors and circuits provided on top of a substrate. One example of this type of application of lithography techniques is the so-called lift-off method. A lift-off method is used, for example, in the production of microstructures within the read portion (the portion of a magnetic head used for reading) of the magnetic head for a magnetic recording medium.

A resist layer formed from a positive resist composition of the present invention and laminated on top of a lower layer can contribute to the formation of a resist pattern with a high aspect ratio, and consequently, a positive resist composition of the present invention can be used favorably within a lift-off method.

### EXAMPLES

As follows is a more detailed description of the present invention using a series of examples, although the present invention is in no way restricted to these examples. Unless stated otherwise, blend quantities and content values refer to % by weight values.

### (Silsesquioxane Resin Synthesis Example 1)

A three neck 500 ml flask fitted with a stirrer, a reflux condenser, a dropping funnel, and a thermometer was charged with 84.0 g (1.0 mol) of sodium hydrogen carbonate and 400 ml of water, a mixed solution containing 51.1 g (0.20 mol) of p-methoxybenzyltrichlorosilane, 21.1 g (0.10 mol) of phenyltrichlorosilane, and 100 ml of diethyl ether was then added dropwise from the dropping funnel over two hours, and the resulting solution was left to age for a further one hour. Following completion of the reaction, the reaction mixture was extracted into ether, and following subsequent removal of the ether under reduced pressure, the resulting hydrolysis product was combined with 0.2 g of a 10% by weight solution of potassium hydroxide and heated for two hours at 200°C, thereby yielding a copolymer A₁ formed from p-methoxybenzylsilsesquioxane and phenylsilsesquioxane.

Subsequently, 50 g of the thus obtained copolymer A₁ was dissolved in 150 ml of acetonitrile, 80 g (0.40 mol) of trimethylsilyl iodide was added, the resulting mixture was stirred for 24 hours under reflux, and then 50 ml of water was added and the mixture was stirred under reflux for a further 12 hours to complete the reaction. Following cooling, any free iodine was reduced using an aqueous solution of sodium hydrogen sulfite, and the organic layer was then separated, the solvent was removed under reduced pressure, and the thus obtained polymer was then reprecipitated from acetone and n-hexane, and then dried by heating under reduced pressure, thus yielding a copolymer A₂ containing 70 mol% ofp-hydroxybenzylsilsesquioxane and 30 mol% of phenylsilsesquioxane.

Subsequently, 40 g of the copolymer A₂ was dissolved in 200 ml of tetrahydrofuran (THF), to the resulting solution were added 1.0 g of p-toluenesulfonic acid monohydrate as an acid catalyst and 5.0 g of ethyl vinyl ether, and the resulting mixture was reacted for approximately 3 hours at 23°C. The reaction solution was then poured into water with constant stirring, thus precipitating the polymer and yielding 40 g of a silsesquioxane resin (X1) represented by a formula (VI) shown below. In the formula, the ratio l:m:n = 50 mol% : 20 mol% : 30 mol%, and the weight average molecular weight of the polymer is 7,500. The polydispersity was approximately 1.7.

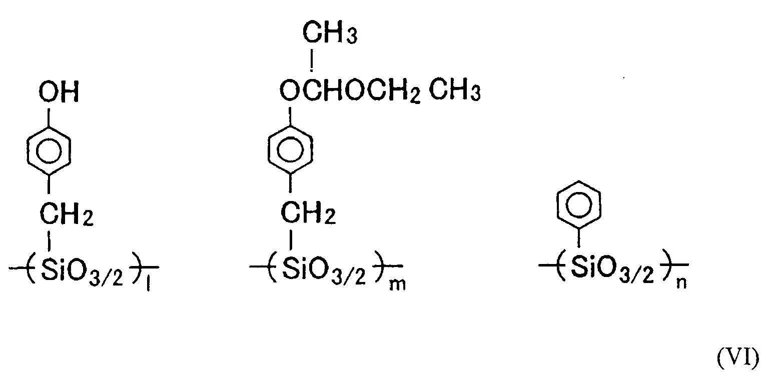

### (Silsesquioxane Resin Synthesis Example 2)

With the exceptions of replacing the ethyl vinyl ether from the above synthesis example 1 with di-tert-butyl dicarbonate, and replacing the catalyst with triethylamine as a basic catalyst, 40 g of a silsesquioxane resin (X2) represented by the chemical formula (VII) shown below was obtained in the same manner as the synthesis example 1. In the formula, the ratio 1:m:n = 50 mol% : 20 mol% : 30 mol%, and the weight average molecular weight of the polymer is 7,500. The polydispersity was approximately 1.7.

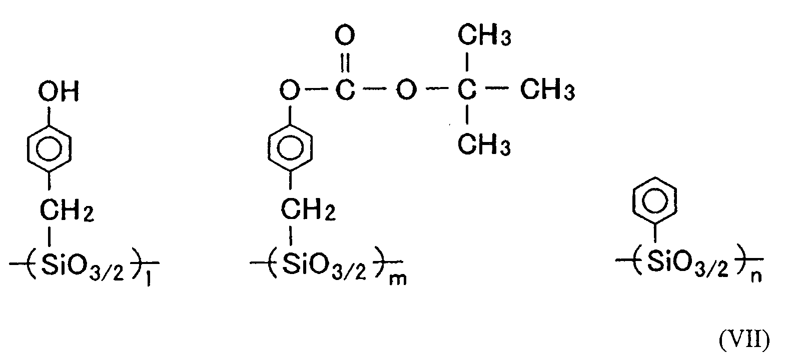

### (Example 1)

100 parts by weight of the silsesquioxane resin (X1) obtained in the above synthesis example 1 was dissolved in 950 parts by weight of ethyl lactate, and 3 parts by weight of triphenylsulfonium trifluoromethanesulfonate, 2 parts by weight of bis(cyclohexylsulfonyl)diazomethane, and 0.25 parts by weight of triethanolamine were added, thus forming a positive resist composition (Si content: 16.20%).

Next, TBLC-100 (manufactured by Tokyo Ohka Kogyo Co., Ltd.) was applied with a spinner to a silicon substrate as a lower organic film material, and this material was then prebaked at 230°C for 90 seconds, thus forming a lower organic layer with a film thickness of 420 nm.

The positive resist composition obtained above was then applied to the surface of the lower organic layer using a spinner, and was then prebaked and dried at 90°C for 90 seconds, thus forming an upper resist layer of film thickness 150 nm, and completing formation of a resist laminate.

Subsequently, this upper resist layer was selectively irradiated with a KrF excimer laser (248 nm) through a half tone mask pattern (transmittance: 6%, mask bias: 40 nm), using a KrF exposure apparatus NSR-S203B (manufactured by Nikon Corporation, NA (numerical aperture) = 0.68, σ = 0.75).

A PEB treatment was then performed at 100°C for 90 seconds, and the resist layer was then developed for 60 seconds at 23°C in a 2.38% by weight aqueous solution of tetramethylammonium hydroxide, thus yielding a contact hole (CH) pattern (I) with a hole diameter of 160 nm.

This CH pattern (I) was then subjected to oxygen plasma dry etching using a high vacuum RIE apparatus (manufactured by Tokyo Ohka Kogyo Co., Ltd.), thus forming a CH pattern (II) in the lower organic layer.

### Pattern Evaluation Method

The edge roughness and rectangularity of the cross-sectional shape of the laminate of the CH patterns (I) and (II) (hereafter referred to as the laminated CH pattern) were determined by inspection of the laminate using a scanning electron microscope (SEM).

In this description, the result of the edge roughness evaluation is recorded as A if the holes are smooth and circular, B if the holes exhibit slight distortion, and C if the holes appear as highly distorted circles. The result of the cross-sectional shape evaluation is reported as A in the case of a circular cylindrical shape with superior verticalness, B in the case of a circular cylindrical shape with acceptable, but somewhat inferior verticalness, and C in the case where the circular cylindrical shape has collapsed.

The laminated CH pattern obtained in this example exhibited an edge roughness result of B, and a cross-sectional shape result of B.

Furthermore in this example, the depth of focus at which a laminated CH pattern with a hole diameter of 160 nm could be produced with favorable shape was 0.5 µm, a satisfactory result.

In addition, the exposure margin across which the laminated CH pattern of hole diameter 160 nm could be obtained within a variation of ±10% was a favorable 15.2%.

### (Example 2)

Using the same procedure as that of the above synthesis example 1, the silsesquioxane resin represented by the above formula (VI) was prepared. However in this example, the ratio 1:m:n was altered to 65 mol% : 20 mol% : 15 mol%. The weight average molecular weight was 6,500.

With the exception of using this silsesquioxane resin, a positive resist composition (Si content: 16.20%) was prepared, a resist laminate was formed, and a laminated CH pattern containing a CH pattern (I) and a CH pattern (II) was formed in the same manner as that described above for the example 1.

The laminated CH pattern obtained in this example exhibited an edge roughness result of A, and a cross-sectional shape result of A.

Furthermore the depth of focus was 0.5 µm, and the exposure margin was a favorable 14.3%.

### (Example 3)

With the exception of using 100 parts by weight of the silsesquioxane resin (X2) obtained in the synthesis example 2, a positive resist composition was prepared, a resist laminate was formed, and a laminated CH pattern containing a CH pattern (I) and a CH pattern (II) was formed in the same manner as that described above for the example 1.

The laminated CH pattern obtained in this example exhibited an edge roughness result of B, and a cross-sectional shape result of A.

Furthermore the depth of focus was 0.5 µm, and the exposure margin was a favorable 10.9%.

### (Comparative Example 1)

Using the procedure disclosed in paragraphs [0076] and [0077] of Japanese Unexamined Patent Application, First Publication No. Hei 9-87391, a silsesquioxane resin represented by a formula (VIII) shown below was prepared. In the formula, l:m = 80 mol% : 20 mol%, and the weight average molecular weight was 5,200.

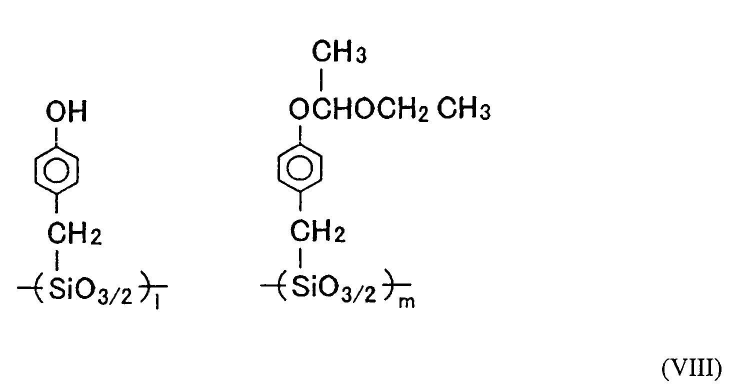

With the exception of using this silsesquioxane resin, a positive resist composition was prepared, a resist laminate was formed, and a laminated CH pattern containing a CH pattern (I) and a CH pattern (II) was formed in the same manner as that described above for the example 1.

The laminated CH pattern obtained in this example exhibited an edge roughness result of C, and a cross-sectional shape result of C.

Furthermore the depth of focus was 0.4 µm, and the exposure margin was 10.8%.

### (Example 4)

TBLC-100 (product name, manufactured by Tokyo Ohka Kogyo Co., Ltd.) was applied with a spinner to a silicon substrate as a lower organic film material, and this material was then prebaked at 230°C for 90 seconds, thus forming a lower organic layer with a film thickness of 455 nm.

The positive resist composition obtained in the example 1 was then applied to the surface of this lower organic layer using a spinner, and was then prebaked and dried at 90°C for 90 seconds, thus forming an upper resist layer of film thickness 200 nm, and completing formation of a resist laminate.

Subsequently, this upper resist layer was selectively irradiated with a KrF excimer laser (248 nm) through a half tone mask pattern (transmittance: 6%, mask bias: 40 nm), using a KrF exposure apparatus NSR-S203B (manufactured by Nikon Corporation, NA (numerical aperture) = 0.68, σ = 0.60).

A PEB treatment was then performed at 100°C for 90 seconds, and the resist layer was then developed for 60 seconds at 23°C in a 2.38% by weight aqueous solution of tetramethylammonium hydroxide, thus yielding a contact hole (CH) pattern (I) with a hole diameter of 160 nm. The pattern was then subjected to post baking at 100°C for 60 seconds.

To this CH pattern (I) was applied a water-soluble resin coating with an overall solid fraction concentration of 8.0% by weight, produced by dissolving 10 g of a copolymer of acrylic acid and vinylpyrrolidone (acrylic acid : vinylpyrrolidone = 2:1 (weight ratio)), 0.1 g of Plysurf A210G (manufactured by Dai-ichi Kogyo Seiyaku Co., Ltd.) as a polyoxyethylene phosphate ester-based surfactant, and 0.9 g of triethanolamine in pure water, thus forming a laminate. The film thickness (the height from the substrate surface) of the water-soluble resin coating in the laminate was 200 nm. This laminate was then subjected to heat treatment, for 60 seconds at either 90°C, 100°C, or 110°C. Subsequently, the substrate was rinsed with pure water at 23°C for 30 seconds, thereby removing the water-soluble resin coating. Finally, the pattern was subjected to post baking at 100°C for 60 seconds.

Using this procedure, the contact hole (CH) pattern with a hole diameter of 160 nm and a pitch of 320 nm was narrowed, yielding a contact hole (CH) pattern with a hole diameter of 130 nm and a pitch of 320 nm.

This narrowed, laminated CH pattern exhibited an edge roughness result of A, and a cross-sectional shape result of B.

Furthermore the depth of focus was 0.40 µm, a satisfactory result.

### (Example 5)

A positive resist composition was prepared in the same manner as the example 1.

TBLC-100 (product name, manufactured by Tokyo Ohka Kogyo Co., Ltd.) was applied with a spinner, as a lower resist material, to a silicon substrate provided with a magnetic film, and this material was then prebaked at 230°C for 90 seconds, thus forming a lower organic layer with a film thickness of 2,500 nm.

The positive resist composition obtained above was then applied to the surface of this lower organic layer using a spinner, and was then prebaked and dried at 95°C for 90 seconds, thus forming an upper resist layer of film thickness 300 nm, and completing formation of a resist laminate.

Subsequently, this upper resist layer was selectively irradiated with a KrF excimer laser (248 nm) using a KrF exposure apparatus NSR-S203B (manufactured by Nikon Corporation, NA (numerical aperture) = 0.68, 2/3 annular illumination).

A PEB treatment was then performed at 95°C for 90 seconds, and the resist layer was then developed for 60 seconds at 23°C in an alkali developing solution, yielding a 250 nm L&S pattern (I). As the alkali developing solution, a 2.38% by weight aqueous solution of tetramethylammonium hydroxide (TMAH) was used. The resulting L&S pattern (I) exhibited a cross-sectional shape with favorable verticalness.

This pattern was then subjected to oxygen plasma dry etching using a high vacuum RIE apparatus (manufactured by Tokyo Ohka Kogyo Co., Ltd.), thereby forming a resist pattern (II) in the lower organic layer.

As a result, a fine thick-film L&S pattern with a film thickness of 2,500 nm and a line width of 250 nm was able to be produced.

In a separate preparation, with the exception of forming a dot pattern (I) with a pattern width of 300 nm, preparation was conducted in the same manner as the case of the L&S pattern described above. As a result, a dot pattern (I) was obtained with a cross-sectional shape of favorable verticalness, and by then employing dry etching, a fine thick-film dot pattern with a film thickness of 2,500 nm and a pattern width of 300 nm was able to be produced.

### (Example 6)

100 parts by weight of the same silsesquioxane resin as that used in the example 1 as the component (A), 8 parts by weight of bis-o-(n-butylsulfonyl)-α-dimethylglyoxime and 0.4 parts by weight of triphenylsulfonium nonafluorobutanesulfonate as the component (B), 1.5 parts by weight of trioctylamine as the component (C), 1.2 parts by weight of salicylic acid as the component (D), and 4 parts by weight of the compound represented by a formula (IX) shown below as a dissolution inhibitor were dissolved uniformly in 950 parts by weight of propylene glycol monomethyl ether acetate, thus yielding a positive resist composition (Si content: 16.2%).

This positive resist composition was applied to the surface of a magnetic film-coated 8 inch silicon substrate provided with a similar lower organic layer (with a film thickness of 2,500 nm) to the example 5. Subsequently, the composition was prebaked and dried at 90°C for 90 seconds, thus forming an upper resist layer of film thickness 300 nm.

Subsequently, this upper resist layer was patterned using an EB lithography apparatus (HL-800D, manufactured by Hitachi High-Technologies Corporation, accelerating voltage 70 kV). A baking treatment was then performed at 100°C for 90 seconds, and the upper resist layer was subjected to development for 60 seconds in a 2.38% aqueous solution of TMAH, rinsed with pure water for 30 seconds, shaken dry, and then subjected to a baking treatment at 100°C for 60 seconds. This process yielded a 150 nm L&S pattern (I) and a 150 nm dot pattern (I).

These resist patterns (I) were subjected to dry etching in the same manner as the example 5, thereby forming resist patterns (II) in the lower organic layer.

As a result, fine thick-film resist patterns with a film thickness of 2,500 nm, including a 150 nm L&S pattern and a 150 nm dot pattern, were able to be produced. 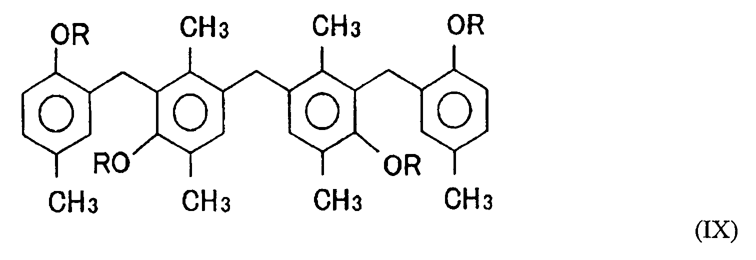 (wherein, R represents a -CH₂COO-tert-butyl group).

### (Example 7)

With the exception of applying the positive resist composition to a hexamethylsilazane-treated 8 inch silicon substrate that contained no lower organic layer, a resist film was formed in the same manner as the example 6. Subsequently, this resist film was subjected to patterning, baking treatment, developing, rinsing, drying, and baking treatment in the same manner as the example 6, yielding a 150 nm L&S pattern. During this process, problems such as pattern collapse and line edge roughness did not arise.

### (Silsesquioxane Resin Synthesis Example 3)

With the exception of replacing the ethyl vinyl ether from the above synthesis example 1 with 6.5 g of cyclohexyl vinyl ether, 40 g of a silsesquioxane resin (X3) represented by the formula (X) shown below was obtained in the same manner as the synthesis example 1. In the formula, the ratio l:m:n = 55 mol% : 15 mol% : 30 mol%, and the weight average molecular weight of the polymer is 7,600.

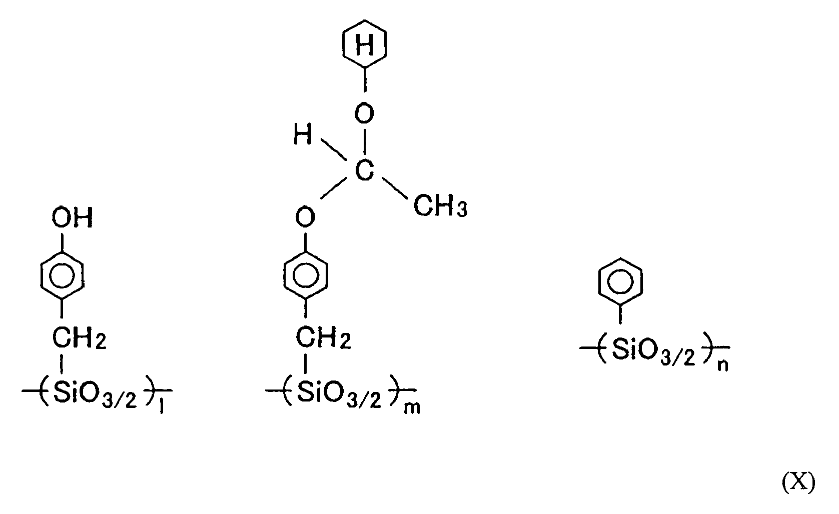

### (Example 8)

100 parts by weight of the silsesquioxane resin (X3) obtained in the above synthesis example 3 was dissolved in 950 parts by weight of ethyl lactate, and 3 parts by weight of triphenylsulfonium trifluoromethanesulfonate, 0.3 parts by weight of triethanolamine, and 15 parts by weight of the dissolution inhibitor represented by the above formula (IX) were added, thus forming a positive resist composition.

Next, TBLC-100 (product name, manufactured by Tokyo Ohka Kogyo Co., Ltd.) was applied with a spinner to a silicon substrate as a lower organic film material, and this material was then prebaked at 230°C for 90 seconds, thus forming a lower organic layer with a film thickness of 420 nm.

The positive resist composition obtained above was then applied to the surface of the lower organic layer using a spinner, and was then prebaked and dried at 100°C for 90 seconds, thus forming an upper resist layer of film thickness 150 nm, and completing formation of a resist laminate.

Subsequently, this upper resist layer was selectively irradiated with a KrF excimer laser (248 nm) through a half tone mask pattern (transmittance: 6%), using a KrF exposure apparatus NSR-S203B (manufactured by Nikon Corporation, NA (numerical aperture) = 0.68, 2/3 annular illumination).

A PEB treatment was then performed at 100°C for 90 seconds, and the resist layer was then developed for 60 seconds at 23°C in a 2.38% by weight aqueous solution of tetramethylammonium hydroxide, thus yielding a 120 nm line and space (L&S) pattern (I).

This L&S pattern (I) was then subjected to oxygen plasma dry etching using a high vacuum RIE apparatus (manufactured by Tokyo Ohka Kogyo Co., Ltd.), thus forming a L&S pattern (II) in the lower organic layer.

### Pattern Evaluation Method

The line edge roughness and rectangularity of the cross-sectional shape of the laminate of the L&S patterns (I) and (II) (hereafter referred to as the laminated L&S pattern) were determined by inspection of the laminate using a scanning electron microscope (SEM).

In this description, the result of the line edge roughness evaluation is recorded as A in the case of almost no roughness, B if the roughness is limited, and C if the roughness distortions are considerable. The result of the cross-sectional shape evaluation is reported as A in the case of a rectangular shape with superior verticalness, B in the case of a rectangular shape with acceptable, but somewhat inferior verticalness, and C in cases where the verticalness is poor resulting in a tapered shape, or in cases where the rectangular shape has collapsed.

The laminated L&S pattern obtained in this example exhibited a line edge roughness result of A, and a cross-sectional shape result of A.

Furthermore in this example, the depth of focus at which a 120 nm laminated L&S pattern could be produced with favorable shape was 0.6 µm, a satisfactory result.

In addition, the exposure margin across which the 120 nm laminated L&S pattern could be obtained within a variation of ±10% was a favorable 7.8%.

### (Example 9)

Using the same procedure as that of the above synthesis example 3, the silsesquioxane resin represented by the above formula (X) was prepared. However in this example, the ratio 1:m:n was altered to 70 mol% : 15 mol% : 15 mol%. The weight average molecular weight was 6,600.

With the exception of using this silsesquioxane resin, a positive resist composition was prepared, a resist laminate was formed, and a laminated L&S pattern containing a L&S pattern (I) and a L&S pattern (II) was formed in the same manner as that described above for the example 8.

The laminated L&S pattern obtained in this example exhibited a line edge roughness result of A, and a cross-sectional shape result of A. Furthermore the depth of focus was 0.6 µm, and the exposure margin was a favorable 6.5%.

### (Comparative Example 2)

Using the procedure disclosed in paragraphs [0076] and [0077] of Japanese Unexamined Patent Application, First Publication No. Hei 9-87391, a silsesquioxane resin represented by a formula (XI) shown below was prepared. In the formula, 1:m = 80 mol% : 20 mol%, and the weight average molecular weight was 5,200.

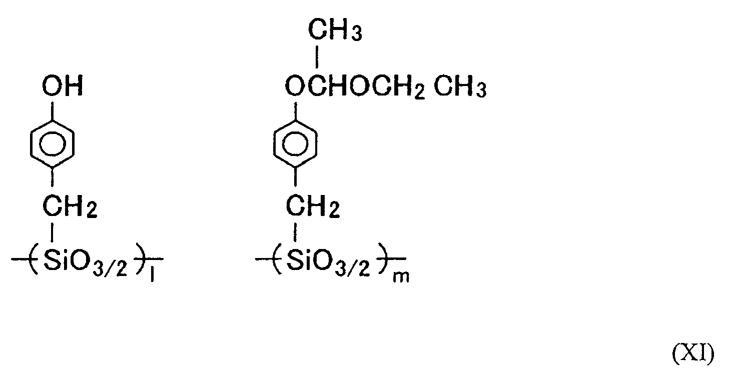

With the exception of using this silsesquioxane resin, a positive resist composition was prepared, a resist laminate was formed, and a laminated L&S pattern containing a L&S pattern (I) and a L&S pattern (II) was formed in the same manner as that described above for the example 8.

The laminated L&S pattern obtained in this example exhibited a line edge roughness result of B, and a cross-sectional shape result of C. Furthermore the depth of focus was 0.4 µm, and the exposure margin was 3.4%.

### (Example 10)

TBLC-100 (product name, manufactured by Tokyo Ohka Kogyo Co., Ltd.) was applied with a spinner to a silicon substrate as a lower organic film material, and this material was then prebaked at 230°C for 90 seconds, thus forming a lower organic layer with a film thickness of 455 nm.

The positive resist composition obtained in the example 8 was then applied to the surface of this lower organic layer using a spinner, and was then prebaked and dried at 100°C for 90 seconds, thus forming an upper resist layer of film thickness 150 nm, and completing formation of a resist laminate.

Subsequently, this upper resist layer was selectively irradiated with a KrF excimer laser (248 nm) through a half tone mask pattern (transmittance: 6%), using a KrF exposure apparatus NSR-S203B (manufactured by Nikon Corporation, NA (numerical aperture) = 0.68, σ = 0.60).

A PEB treatment was then performed at 100°C for 90 seconds, and the resist layer was then developed for 60 seconds at 23°C in a 2.38% by weight aqueous solution of tetramethylammonium hydroxide, thus yielding a 140 nm trench pattern (I). The pattern was then subjected to post baking at 100°C for 60 seconds.

To this pattern (I) was applied a water-soluble resin coating with an overall solid fraction concentration of 8.0% by weight, produced by dissolving 10 g of a copolymer of acrylic acid and vinylpyrrolidone (acrylic acid : vinylpyrrolidone = 2:1 (weight ratio)), 0.1 g of Plysurf A210G (manufactured by Dai-ichi Kogyo Seiyaku Co., Ltd.) as a polyoxyethylene phosphate ester-based surfactant, and 0.9 g of triethanolamine in pure water, thus forming a laminate. The film thickness (the height from the substrate surface) of the water-soluble resin coating in the laminate was 200 nm. This laminate was then subjected to heat treatment, for 60 seconds at either 90°C, 100°C, or 110°C. Subsequently, the substrate was rinsed with pure water at 23°C for 30 seconds, thereby removing the water-soluble resin coating. Finally, the pattern was subjected to post baking at 100°C for 60 seconds.

Using this procedure, the 140 nm trench pattern was narrowed, yielding a 110 nm trench pattern.

This narrowed, laminated pattern exhibited an edge roughness result of A, and a cross-sectional shape result of B.

Furthermore the depth of focus was 0.40 µm, a satisfactory result.

### (Example 11)

A positive resist composition was prepared in the same manner as the example 8.

TBLC-100 (product name, manufactured by Tokyo Ohka Kogyo Co., Ltd.) was applied with a spinner, as a lower resist material, to a silicon substrate provided with a magnetic film, and this material was then baked at 230°C for 90 seconds, thus forming a lower organic layer with a film thickness of 2,500 nm.

The positive resist composition obtained above was then applied to the surface of this lower organic layer using a spinner, and was then prebaked and dried at 95°C for 90 seconds, thus forming an upper resist layer of film thickness 300 nm, and completing formation of a resist laminate.

Subsequently, this upper resist layer was selectively irradiated with a KrF excimer laser (248 nm) using a KrF exposure apparatus NSR-S203B (manufactured by Nikon Corporation, NA (numerical aperture) = 0.68, 2/3 annular illumination).

A PEB treatment was then performed at 95°C for 90 seconds, and the resist layer was then developed for 60 seconds at 23°C in an alkali developing solution, yielding a 250 nm L&S pattern (I). As the alkali developing solution, a 2.38% by weight aqueous solution of tetramethylammonium hydroxide (TMAH) was used. The resulting L&S pattern (I) exhibited a cross-sectional shape with favorable verticalness.

This pattern was then subjected to oxygen plasma dry etching using a high vacuum RIE apparatus (manufactured by Tokyo Ohka Kogyo Co., Ltd.), thereby forming a resist pattern (II) in the lower organic layer.

As a result, a fine thick-film laminated resist pattern with a film thickness of 2,500 nm and a line width of 250 nm was able to be produced.

In a separate preparation, with the exception of forming a dot pattern (I) with a pattern width of 300 nm, preparation and alkali developing was conducted in the same manner as the case of the L&S pattern described above. As a result, a dot pattern (I) was obtained with a cross-sectional shape of favorable verticalness, and by then employing dry etching, a fine thick-film laminated resist pattern with a film thickness of 2,500 nm and a dot width of 300 nm was able to be produced.

### (Example 12)

100 parts by weight of the same silsesquioxane resin as that used in the example 8 as the component (A), 8 parts by weight of bis-o-(n-butylsulfonyl)-α-dimethylglyoxime and 0.4 parts by weight of triphenylsulfonium nonafluorobutanesulfonate as the component (B), 1.5 parts by weight of trioctylamine as the component (C), 1.2 parts by weight of salicylic acid as the component (D), and 4 parts by weight of the compound represented by the formula (IX) shown above as a dissolution inhibitor were dissolved uniformly in 950 parts by weight of propylene glycol monomethyl ether acetate, thus yielding a positive resist composition in a similar manner to the example 8.

This positive resist composition was applied to the surface of a magnetic film-coated 8 inch silicon substrate provided with a similar lower organic layer (with a film thickness of 2,500 nm) to the example 11. Subsequently, the composition was prebaked and dried at 90°C for 90 seconds, thus forming an upper resist layer of film thickness 300 nm.

Subsequently, this upper resist layer was patterned using an EB lithography apparatus (HL-800D, manufactured by Hitachi High-Technologies Corporation, accelerating voltage 70 kV). A baking treatment was then performed at 100°C for 90 seconds, and the upper resist layer was subjected to development for 60 seconds in a 2.38% aqueous solution of TMAH, rinsed with pure water for 30 seconds, shaken dry, and then subjected to a baking treatment at 100°C for 60 seconds. This process yielded a 150 nm L&S pattern (I) and a 150 nm dot pattern (I).

These resist patterns (I) were subjected to dry etching in the same manner as the example 11, thereby forming resist patterns (II) in the lower organic layer.

As a result, fine thick-film laminated resist patterns with a film thickness of 2,500 nm, including a 150 nm L&S pattern and a 150 nm dot pattern, were able to be produced.

### (Example 13)

With the exception of applying the positive resist composition to a hexamethylsilazane-treated 8 inch silicon substrate that contained no lower organic layer, a resist film was formed in the same manner as the example 12. Subsequently, this resist film was subjected to patterning, baking treatment, developing, rinsing, drying, and baking treatment in the same manner as the example 12, yielding a single-layer 150 nm line and space pattern. During this process, problems such as pattern collapse and line edge roughness did not arise.

## Claims

1. A positive resist composition, comprising a resin component (A) that exhibits increased alkali solubility under action of acid, and an acid generator component (B) that generates acid on exposure, wherein
said component (A) comprises a silsesquioxane resin (A1) containing structural units (a1) represented by a general formula (I) shown below, structural units (a2) represented by a general formula (II) shown below, and structural units (a3) represented by a general formula (III) shown below: 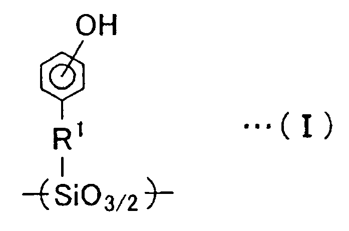 (wherein, R¹ represents a straight-chain or branched alkylene group of 1 to 5 carbon atoms) 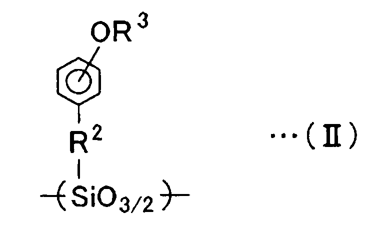 (wherein, R² represents a straight-chain or branched alkylene group of 1 to 5 carbon atoms, and R³ represents an acid dissociable, dissolution inhibiting group)

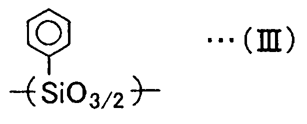

2. A positive resist composition according to claim 1, wherein a quantity of a combination of said structural units (a1) and (a2), relative to a combined total of all structural units within said component (A1), is at least 50 mol%, and a quantity of said structural units (a2), relative to said combination of said structural units (a1) and (a2), is at least 10 mol%.

3. A positive resist composition, comprising a resin component (A) that exhibits increased alkali solubility under action of acid, and an acid generator component (B) that generates acid on exposure, wherein
said component (A) comprises a silsesquioxane resin (A2) containing structural units (a1) represented by a general formula (I) shown below, and structural units (a2') represented by a general formula (II') shown below: 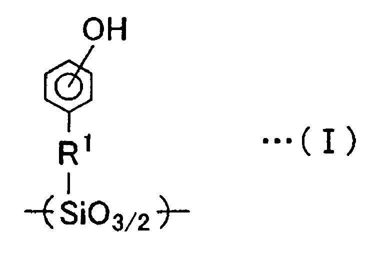 (wherein, R¹ represents a straight-chain or branched alkylene group of 1 to 5 carbon atoms) 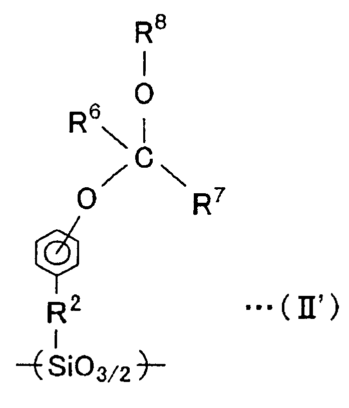 (wherein, R² represents a straight-chain or branched alkylene group of 1 to 5 carbon atoms, R⁶ represents an alkyl group of 1 to 5 carbon atoms, R⁷ represents either an alkyl group of 1 to 5 carbon atoms or a hydrogen atom, and R⁸ represents an alicyclic hydrocarbon group of 5 to 15 carbon atoms).

4. A positive resist composition according to claim 3, wherein said component (A2) further comprises structural units (a3) represented by a general formula (III) shown below.

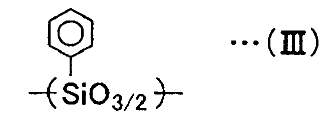

5. A positive resist composition according to claim 3, wherein a quantity of a combination of said structural units (a1) and (a2'), relative to a combined total of all structural units within said component (A), is at least 50 mol%, and a quantity of said structural units (a2'), relative to said combination of said structural units (a1) and (a2'), is at least 5 mol%, but no more than 50 mol%.

6. A positive resist composition according to either one of claim 1 and claim 3, further comprising a dissolution inhibitor (C) in addition to said component (A) and said component (B).

7. A positive resist composition according to either one of claim 1 and claim 3, wherein said positive resist composition is used for exposure with a KrF excimer laser or an electron beam.

8. A positive resist composition according to either one of claim 1 and claim 3, wherein said composition is used for forming a resist layer, either on top of a substrate and a magnetic film provided on top of said substrate, or on top of a metallic oxidation prevention film provided on top of said magnetic film.

9. A resist laminate, comprising a lower organic layer and an upper resist layer laminated on top of a support, wherein
said lower organic layer is insoluble in alkali developing solution, but can by dry etched, and
said upper resist layer comprises a positive resist composition according to either one of claim 1 and claim 3.

10. A resist laminate according to claim 9, wherein a thickness of said lower organic layer is within a range from 300 to 20,000 nm, and a thickness of said upper resist layer is within a range from 50 to 1,000 nm.

11. A process for forming a resist pattern, comprising:
a laminate formation step of forming a resist laminate according to claim 9;
a first pattern formation step of conducting selective exposure of said resist laminate, performing post exposure baking (PEB), and conducting alkali developing to form a resist pattern (I) in said upper resist layer;
a second pattern formation step of conducting dry etching using said resist pattern (I) as a mask, thereby forming a resist pattern (II) in said lower organic layer; and
an etching step of conducting etching using said resist pattern (I) and said resist pattern (II) as a mask, thereby forming a fine pattern in said support.

12. A process for forming a resist pattern according to claim 11, wherein dry etching in said second pattern formation step is etching using an oxygen plasma.

13. A process for forming a resist pattern according to claim 11, wherein etching in said etching step is etching using a halogen-based gas.

14. A process for forming a resist pattern according to claim 11, further comprising, prior to said second pattern formation step, a step of providing a water-soluble resin coating comprising a water-soluble polymer on top of said resist pattern (I) and then conducting heating, thereby narrowing a spacing within said resist pattern (I).

15. A process for forming a resist pattern according to claim 14, wherein a material comprising structural units derived from at least one monomer which acts as a proton donor, and structural units derived from at least one monomer which acts as a proton acceptor is used as said water-soluble polymer.
